# EUROPEAN PATENT APPLICATION

(11) **EP 4 669 057 A1**
(43) Date of publication of application: **24.12.2025**
(21) Application number: 25184144.1
(22) Date of filing: 20.06.2025
(51) Int. Cl.: H10D 86/40

(54) **DISPLAY DEVICE AND ELECTRONIC DEVICE**

(30) Priority: 21.06.2024 KR 20240081270; 13.08.2024 KR 20240108343
(71) Applicant: Samsung Display Co., Ltd., Yongin-si, Gyeonggi-do 17113 (KR)
(72) Inventor: PARK, Hyung Keun, 17113 Yongin-si (KR); LEE, Jong Hyeon, 17113 Yongin-si (KR); LIM, Chan Young, 17113 Yongin-si (KR); GU, Won Ji, 17113 Yongin-si (KR); SHIN, Hyun Do, 17113 Yongin-si (KR); YEO, Min Kyu, 17113 Yongin-si (KR)
(74) Representative: Taor, Simon Edward William

(57) **Abstract**

A display device includes: a substrate comprising a display area and a non-display area; a signal line extending in a first direction across the display area and the non-display area; and a power line overlapping with the signal line in the non-display area, and extending in a second direction different from the first direction, wherein the signal line comprises a first sub signal line and a second sub signal line, the power line comprises a first sub power line and a second sub power line connected through a first contact hole, and the first contact hole is spaced apart in the second direction from an overlapping area of the first sub signal line and the second sub signal line.

## Description

### CROSS-REFERENCE TO RELATED PATENT APPLICATION

The present application claims priority to Korean Patent Application Number 10-2024-0081270, filed on June 21, 2024, and Korean Patent Application Number 10-2024-0108343, filed on August 13, 2024, in the Korean Intellectual Property Office.

### BACKGROUND

### 1. Field

Aspects of some embodiments of the present disclosure relate to a display device and an electronic device.

### 2. Description of the Related Art

As information technology develops, the importance of display devices which are a connecting medium between users and information is emphasized. In response to this, the use of display devices such as liquid crystal display devices, organic light emitting display devices, and inorganic light emitting display devices is increasing.

A display panel may include a display area for displaying images and a non-display area for displaying no images. For aesthetics and functionality, the display area is widening and the non-display area is narrowing.

Here, as the non-display area is narrowed, there is a problem that it is not easy to arrange and configure lines positioned in the non-display area.

The above information disclosed in this Background section is only for enhancement of understanding of the background and therefore the information discussed in this Background section does not necessarily constitute prior art.

### SUMMARY

Aspects of some embodiments include a display device and an electronic device including a reliable power line.

A display device according to some embodiments of the present disclosure includes: a substrate including a display area and a non-display area; a signal line extending in a first direction across the display area and the non-display area; and; and a power line overlapping with the signal line in the non-display area, and extending in a second direction different from the first direction, the signal line includes a first sub signal line and a second sub signal line, the power line includes a first sub power line and a second sub power line connected through a first contact hole, and the first contact hole is spaced apart in the second direction from an overlapping area of the first sub signal line and the second sub signal line.

According to some embodiments, the first contact hole may be spaced apart from the overlapping area by 2 micrometers or more.

According to some embodiments, a first electrode layer may include the first sub signal line, a second electrode layer may be positioned on the first electrode layer, and include the second sub signal line, a third electrode layer may be positioned on the second electrode layer, and include the first sub power line, and a fourth electrode layer may be positioned on the third electrode layer, and include the second sub power line.

According to some embodiments, the first electrode layer may include a gate electrode of a first transistor, and the third electrode layer may include a gate electrode of a second transistor.

According to some embodiments, a channel of the first transistor and a channel of the second transistor may include different semiconductor materials.

According to some embodiments, the second sub signal line may include an extension extending in the second direction, and the first contact hole may be positioned on the extension.

According to some embodiments, the first sub signal line may include an extension extending in the second direction, and the first contact hole may be positioned on the extension.

According to some embodiments, the first contact hole may overlap with neither the first sub signal line nor the second sub signal line.

According to some embodiments, the first sub power line and the second sub power line each may extend in the second direction, and the first sub power line and the second sub power line may be further connected through a second contact hole positioned in the second direction from the first contact hole.

According to some embodiments, a display device includes: a substrate including a display area and a non-display area; a signal line extending in a first direction across the display area and the non-display area; and; and a power line overlapping with the signal line in the non-display area, and extending in a second direction different from the first direction, the signal line includes a first sub signal line and a second sub signal line, the power line includes a first sub power line, a second sub power line, and a third sub power line connected to the second sub power line through a first contact hole, and the first contact hole is spaced apart in the second direction from an overlapping area of the first sub signal line and the second sub signal line.

According to some embodiments, the first contact hole may be spaced apart from the overlapping area by 2 micrometers or more.

According to some embodiments, a first electrode layer may include the first sub signal line, a second electrode layer may be positioned on the first electrode layer, and include the second sub signal line, a third electrode layer may be positioned on the second electrode layer, and include the first sub power line, an additional electrode layer may be positioned on the third electrode layer, and include the second sub power line, and a fourth electrode layer may be positioned on the additional electrode layer, and include the third sub power line.

According to some embodiments, the first electrode layer may include a gate electrode of a first transistor, and the third electrode layer may include a gate electrode of a second transistor.

According to some embodiments, a channel of the first transistor and a channel of the second transistor may include different semiconductor materials.

According to some embodiments, the second sub signal line may include an extension extending in the second direction, and the first contact hole may be positioned on the extension.

According to some embodiments, the second sub signal line may include an extension extending in the second direction, and the first contact hole may be positioned on the extension.

According to some embodiments, the first contact hole may overlap with neither the first sub signal line nor the second sub signal line.

According to some embodiments, the first sub power line, the second sub power line, and the third sub power line each may extend in the second direction, and the second sub power line and the third sub power line may be further connected through a second contact hole positioned in the second direction from the first contact hole.

According to some embodiments, the second sub power line and the third sub power line may be further connected through a third contact hole positioned in a direction opposite to the first direction from the first contact hole, and the third contact hole may not overlap with the first sub power line.

According to some embodiments, the second sub power line and the third sub power line may be further connected through a fourth contact hole positioned in the second direction from the third contact hole, and the fourth contact hole may not overlap with the first sub power line.

An electronic device according to some embodiments of the present disclosure includes: a processor to provide input image data; and a display device to display an image based on the input image data. The display device includes: a substrate including a display area and a non-display area; a signal line extending in a first direction across the display area and the non-display area; and a power line overlapping with the signal line in the non-display area, and extending in a second direction different from the first direction. The signal line includes a first sub signal line and a second sub signal line, the power line includes a first sub power line and a second sub power line connected through a first contact hole, and the first contact hole is spaced apart in the second direction from an overlapping area of the first sub signal line and the second sub signal line.

According to an aspect, there is provided a display device as set out in claim 1. Additional features are set out in claims 2 to 8. According to an aspect, there is provided a display device as set out in claim 9. Additional features are set out in claims 10 to 14. According to an aspect, there is provided an electronic device as set out in claim 15.

According to some embodiments, a display device and an electronic device may include a reliable power line.

### BRIEF DESCRIPTION OF THE DRAWINGS

FIG. 1 and FIG. 2 are diagrams for illustrating a display device according to some embodiments of the present disclosure.
FIG. 3 is a diagram for illustrating a pixel according to some embodiments of the present disclosure.
FIG. 4 is a diagram for illustrating an optical sensor according to some embodiments of the present disclosure.
FIG. 5 is a diagram for illustrating a driving method of a pixel and an optical sensor according to some embodiments of the present disclosure.
FIG. 6 and FIG. 7 are drawings for illustrating relationship of pads, connection lines, and signal lines according to some embodiments of the present disclosure.
FIG. 8 is a diagram for illustrating a stacking structure of a display area of a display panel according to some embodiments.
FIG. 9 is a plan view of an area of interest according to some embodiments of the present disclosure.
FIG. 10 is a cross-sectional diagram along a line Aa-Ba of an area of interest of FIG. 9.
FIG. 11 is a plan view of an area of interest according to some embodiments of the present disclosure.
FIG. 12 is a cross-sectional diagram along a line Ab-Bb of an area of interest of FIG. 11.
FIG. 13 is a plan view of an area of interest according to some embodiments of the present disclosure.
FIG. 14 is a cross-sectional diagram along a line Ac-Bc of an area of interest of FIG. 13.
FIG. 15 is a plan view of an area of interest according to some embodiments of the present disclosure.
FIG. 16 is a cross-sectional diagram along a line Ad-Bd of an area of interest of FIG. 15.
FIG. 17 is a diagram for illustrating a stacking structure of a display area of a display panel according to some embodiments.
FIG. 18 is a plan view of an area of interest according to some embodiments of the present disclosure.
FIG. 19 is a cross-sectional diagram along a line Ae-Be of an area of interest of FIG. 18.
FIG. 20 is a cross-sectional diagram along a line Ce-De of an area of interest of FIG. 18.
FIG. 21 is a plan view of an area of interest according to some embodiments of the present disclosure.
FIG. 22 is a cross-sectional diagram along a line Af-Bf of an area of interest of FIG. 21.
FIG. 23 is a cross-sectional diagram along a line Cf-Df of an area of interest of FIG. 21.
FIG. 24 is a plan view of an area of interest according to some embodiments of the present disclosure.
FIG. 25 is a cross-sectional diagram along a line Ag-Bg of an area of interest of FIG. 24.
FIG. 26 is a cross-sectional diagram along a line Cg-Dg of an area of interest of FIG. 24.
FIG. 27 is a plan view of an area of interest according to some embodiments of the present disclosure.
FIG. 28 is a cross-sectional diagram along a line Ah-Bh of an area of interest of FIG. 27.
FIG. 29 is a cross-sectional diagram along a line Ch-Dh of an area of interest of FIG. 28.
FIG. 30 is a block diagram of an electronic device according to an embodiment.
FIGS. 31 to 33 shows schematic views of various embodiments of an electronic device.

### DETAILED DESCRIPTION

Hereinafter, several embodiments of the present disclosure will be described in detail with reference to the accompanying drawings so that a person skilled in the art to which the present disclosure pertains may easily implement them. The present disclosure may be embodied in various different forms and is not limited to the embodiments described herein.

To clearly explain the present disclosure, a part irrelevant to the description is omitted, and the same reference numeral is given for the same or similar component throughout the specification. Hence, the reference numeral described previously may be used in another drawing as well.

In addition, a size and a thickness of each configuration shown in the drawings are arbitrarily presented for ease of explanation, and accordingly the present disclosure is not necessarily limited to the drawings. The thicknesses may be exaggerated to clearly represent different layers and areas in the drawings.

Further, the expression "the same" or "identical" in the description may refer to "substantially the same" or "substantially identical". In other words, this expression may indicate that two parts are so identical that a person skilled in the art would be convinced that they are identical. Other expressions may also be expressions from which the word "substantially" is omitted.

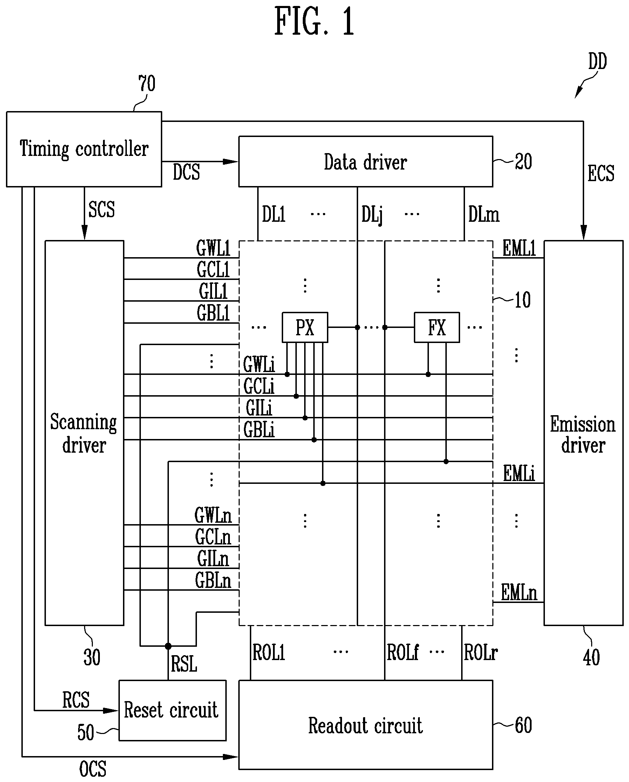

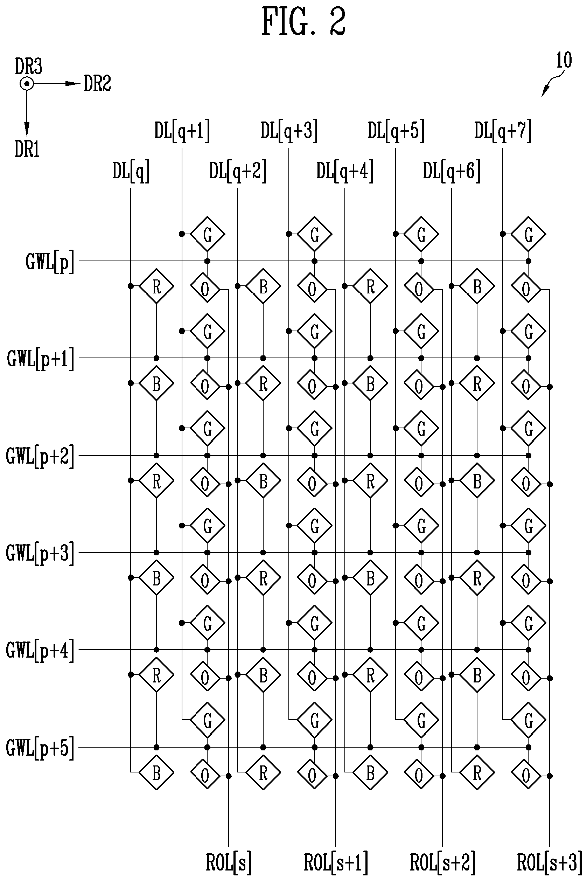

FIG. 1 and FIG. 2 are drawings for illustrating a display device according to some embodiments of the present disclosure. Referring to FIG. 1, a display device DD according to some embodiments of the present disclosure may be a portable electronic device such as a mobile phone, a smart phone, a tablet PC, a mobile communications terminal, an electronic notebook, an electronic book, a portable multimedia player (PMP), a navigation device and a ultra mobile PC (UMPC). In addition, the display device DD according to some embodiments of the present disclosure may include a display panel of a television, a laptop computer, a monitor, an electronic billboard, or an Internet of Things (IOT) device. In addition, the display device DD according to some embodiments of the present disclosure may be a wearable device such as a smart watch, a watch phone, a glasses-type display, and a head-mounted display (HMD) device.

Referring to FIG. 1, a display device (DD) according to some embodiments of the present disclosure may include a display panel 10, a data driver 20, a scanning driver 30, an emission driver 40, a reset circuit 50, a readout circuit 60, and a timing controller 70.

The timing controller 70 may receive grayscales and timing signals for frame periods respectively from a processor. Herein, the processor may be at least one of a graphics processing unit (GPU), a central processing unit (CPU), an application processor (AP) and so on. The timing signals may include a vertical synchronization signal, a horizontal synchronization signal, a data enable signals, and so on.

Each cycle of the vertical synchronization signal may correspond to a different frame period. Each cycle of the horizontal synchronization signal may correspond to each horizontal period. The grayscales may be provided based on a horizontal line unit in each horizontal period in response to a pulse of an enable level of the data enable signal. The horizontal line may indicate pixels (e.g., a pixel row) connected to the same scanning line and emission line.

The timing controller 70 may generate a first control signal (SCS), a second control signal (ECS), a third control signal (DCS), a fourth control signal (RCS), and a fifth control signal (OCS) based on the received grayscales and timing signals. The first control signal (SCS) may be fed into the scanning driver 30, the second control signal (ECS) may be fed into the emission driver 40, the third control signal (DCS) may be fed into the data driver 20, the fourth control signal (RCS) may be fed into the reset circuit 50, and the fifth control signal (OCS) may be fed into the readout circuit 60. The timing controller 70 may rearrange (e.g., render) and compensate the grayscales and provide to the data driver 20.

The display panel 10 may include pixels (PX) connected to data lines (DL1, ..., DLj, ..., DLm), scanning lines (GWL1, ..., GWLi, ..., GWLn, GCL1, ..., GCLi, ..., GCLn, GIL1, ..., GILi, ..., GILn, GBL1, ..., GBLi, ..., GBLn), and emission lines (EML1, ..., EMLi, ..., EMLn). Each pixel (PX) may include a light emitting element for receiving a data voltage from a corresponding data line, and emitting light with a luminance based on the data voltage. In addition, the display panel 10 may include optical sensors (FX) connected to first scanning lines (GWL1, ..., GWLi, ..., GWLn), a reset line (RSL), and readout lines (ROL1, ..., ROLf, ..., ROLr). The optical sensors (FX) each may include a light receiving element, and provide a corresponding readout line with a sensing current generated based on the amount of light received by the light receiving element. Herein, m, n, and r may be integers greater than 1.

The data driver 20 may receive the grayscales and the third control signal (DCS) from the timing controller 70. For example, the third control signal (DCS) may include a source start signal, a clock signal, and so on. For example, the data driver 20 may sample the grayscales while shifting the source start signal based on the clock signal, and apply data voltages corresponding to the sampled grayscales to the data lines (DL1~DLm) based on the pixel row unit.

The scanning driver 30 may receive the first control signal (SCS) from the timing controller 70. The first control signal (SCS) may include a clock signal, a scanning start signal, and so on. The scanning driver 30 may provide scanning signals to the scanning lines (GWL1, ..., GWLi, ..., GWLn, GCL1, ..., GCLi, ..., GCLn, GIL1, ..., GILi, ..., GILi, ..., GILn, GBL1, ..., GBLi, ..., GBLn, GBLn, ..., GBLn) in response to the first control signal (SCS).

FIG. 1 illustrates embodiments configured by connecting the scanning lines (GWL1, ..., GWLi, ..., GWLn, GCL1, ..., GCLi, ..., GCLn, GIL1, ..., GILi, ..., GILn, GBL1, ..., GBLi, ..., GBLn, GBLn, GBLn) to the single scanning driver 30, but embodiments are not limited thereto. For example, the scanning driver 30 may include a first sub scanning driver connected to the first scanning lines (GWL1, ..., GWLi, ..., GWLn), a second sub scanning driver connected to second scanning lines (GCL1, ..., GCLi, ..., GCLn), a third sub scanning driver connected to third scanning lines (GIL1, ..., GILi, ..., GILn), and a fourth sub scanning driver connected to fourth scanning lines (GBL1, ..., GBLi, ..., GBLn). In another example, the scanning driver 30 may be configured to include a first sub scanning driver connected to the scanning lines (GWL1, ..., GWLi, ..., GWLn, GBL1, ..., GBLi, ..., GBLn) and a second sub scanning driver connected to the scanning lines (GCL1, ..., GCLi, ..., GCLn, GIL1, ..., GILi, ..., GILn).

The scanning driver 30 or each sub scanning driver may sequentially provide the scanning signals having turn-on-level pulses to corresponding scanning lines. The scanning driver 30 or each sub scanning driver may include scanning stages configured in the form of shift registers. The scanning driver 30 or each sub scanning driver may generate the scanning signals by sequentially transmitting the scanning start signal in the form of the turn-on level pulse to a next scanning stage under control of the clock signal.

The emission driver 40 may receive the second control signal (ECS) from the timing controller 70. The second control signal (ECS) may include a clock signal, an emission stop signal, and so on. The emission driver 40 may supply emission signals to the emission lines (EML1~EMLn) in response to the second control signal (ECS).

The emission driver 40 may sequentially provide the emission signals having turn-off level pulses to the emission lines (EML1~EMLn). The emission driver 40 may include emission stages configured in the form of shift registers. The emission driver 40 may generate the emission signals by sequentially transmitting the emission stop signal in the form of the turn-off level pulse to a next emission stage under control of the clock signal.

FIG. 1 illustrates aspects of embodiments which provide the scanning driver 30 and the emission driver 40 as separate configurations, but embodiments according to the present disclosure are not limited thereto. For example, the scanning driver 30 and the emission driver 40 may be integrated into one driving circuit or one module, and so on.

The reset circuit 50 may receive the fourth control signal (RCS) from the timing controller 70. The reset circuit 50 may apply a reset signal to the reset line (RSL) in response to the fourth control signal (RCS). The reset line (RSL) may be connected in common to all of the optical sensors (FX) of the display panel 10. In other words, the common reset signal may be transmitted to all of the optical sensors (FX). Meanwhile, according to some embodiments, the reset circuit 50 may be connected to a plurality of optical sensors (FX) through a plurality of reset lines. In this case, a plurality of different reset signals may be transmitted to different optical sensors (FX).

For sensing, at least some of the pixels (PXs) positioned in a selected area may emit light in a sensing pattern. The sensing pattern may be a single color pattern (e.g., a red pattern or a green pattern). Meanwhile, the optical sensors (FX) may generate sensing signals corresponding to the amount of the received light. Pixels (PXs) positioned outside the selected area may keep displaying an existing image. Because a user may not recognize the sensing pattern of pixels (PX) positioned in the selected area covered by a finger, the user may continue to view the existing image.

The readout circuit 60 may receive the fifth control signal (OCS) from the timing controller 70. The readout circuit 60 may provide sensing information based on the sensing signals received from the readout lines (ROL1~ROLr) in response to the fifth control signal (OCS). The sensing information may be configured in various manners depending on a mode of the display device (DD). For example, the sensing information may be fingerprint image information, photoplethysmography (PPG) information, and the like.

The processor or the timing controller 70 may perform a user authentication function by using the sensing information provided from the readout circuit 60.

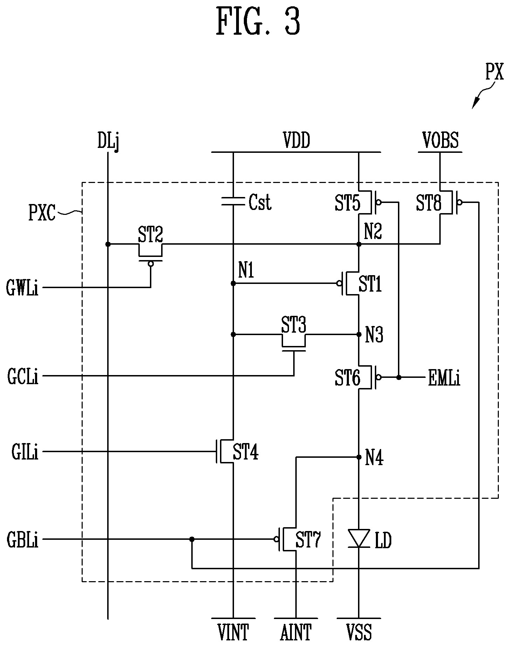

Referring to FIG. 2, in display panel 10, example connections of first scanning lines (GWL[p]~GWL[p+5]), data lines (DL[q]~DL[q+7]), readout lines (ROL[s]~ROL[s+3]), pixels (PX), and optical sensors (FX) are depicted. Connections between other scanning lines (GCL1~GCLn, GIL1~GILn, GBL1~GBLn) and emission lines (EML1~EMLn) and the pixels (PX) shown in FIG. 1 refer to FIG. 3.

The pixels (PX) may be connected to the first scanning lines (GWL[p]~GWL[p+5]), and may include light emitting elements (R, G, B). The first scanning lines (GWL[p]~GWL[p+5]) may be arranged in parallel in a first direction (DR1). The first scanning lines (GWL[p]~GWL[p+5]) may extend in a second direction (DR2). p may be an integer greater than zero. In addition, the pixels (PX) may be connected to the data lines (DL[g]~DL[g+7]). The data lines (DL[q]~DL[q+7]) may extend in the first direction (DR1), and arranged parallel to each other in the second direction (DR2). q may be an integer greater than zero.

Each of the light emitting elements (R, G, B) of the pixels (PX) may emit one of light of a first color, light of a second color, and light of a third color. The first color, the second color, and the third color may be different colors. For example, the first color may be one of red, green, and blue, the second color may be another color, which is not the first color, of red, green, and blue, and the third color may be the other color of red, green, and blue, which is not the first color and the second color. Also, magenta, cyan, and yellow may be used instead of red, green, and blue as the first through third colors. Hereafter, a case where the first color is red, the second color is green, and the third color is blue is explained by way of example.

These embodiments illustrate that the light emitting elements (R, G, B) of the pixels (PX) are arranged in a diamond pixel (DIAMOND PIXEL^{™}) or pentile (PENTILE^{™}) structure or arrangement as an example. The connections of the first scanning lines (GWL[p]~GWL[p+5]), the data lines (DL[q]~DL[q+7]), and the pixels (PX) shown are illustrative, and may be changed. For example, the pixels (PXs) including the light emitting elements (R, B) of the first color and the third color may be connected together to the same data line (DL[q], DL[q+2], DL[q+4], or DL[q+6]), and the pixels (PXs) including the light emitting elements (G) of the second color may be connected to an independent data line (DL[q+1], DL[q+3], DL[q+5], or DL[q+7]). The data lines (DL[q], DL[q+2], DL[q+4], or DL[q+6]) connected with the pixels (PX) including the light emitting elements (R, B) of the first color and the third color and the data lines (DL[q+1], DL[q+3], DL[q+5], or DL[q+7]) connected with the pixels (PX) including the light emitting elements (G) of the second color may be arranged alternately in the second direction (DR2).

The optical sensors (FX) including light receiving elements (O) may be connected to the first scanning lines (GWL[p]~GWL[p+5]) and readout lines (ROL[s]~ROL[s+3]). The readout lines (ROL[s]~ROL[s+3]) may extend in the first direction (DR1), and arranged parallel to each other in the second direction (DR2).

FIG. 3 is a diagram for illustrating a pixel according to some embodiments of the present disclosure. Although FIG. 3 illustrates various components in a pixel according to some embodiments, embodiments according to the present disclosure are not limited thereto, and according to some embodiments, the pixel may include additional components or fewer components without departing from the scope of embodiments according to the present disclosure.

FIG. 3 illustratively illustrates a pixel (PX) located in an i-th pixel row and a j-th pixel column among a plurality of pixels (PX). A pixel row may indicate pixels connected to the same scanning line and emission line, and a pixel column may indicate pixels connected to the same data line. Herein, i is an integer greater than or equal to 1 and smaller than or equal to n, and j is an integer greater than or equal to 1 and smaller than or equal to m.

Referring to FIG. 3, the pixel (PX) may include a pixel circuit (PXC) and a light emitting element (LD). The pixel circuit (PXC) may include pixel transistors (ST1~ST8) and storage capacitors (Cst).

A gate electrode of the first pixel transistor (ST1, a driving transistor) may be connected to a first node (N1), a first electrode may be connected to a second node (N2), and a third electrode may be connected to a third node (N3). The first pixel transistor (ST1) may control a driving current flowing from a first power voltage (VDD) to a second power voltage (VSS) via the light emitting element (LD), in response to a voltage of the first node (N1).

A first electrode of the second pixel transistor (ST2, a switching transistor) may be connected to the data line (DLj), a second electrode may be connected to the second node (N2), and a gate electrode may be connected to the first scanning line (GWLi). The second pixel transistor (ST2) may be turned on if a first scanning signal of the turn-on level is supplied to the first scanning line (GWLi), to electrically connect the data line (DLj) to the second node (N2).

A first electrode of the third pixel transistor (ST3, a diode connected transistor) may be connected to the first node (N1), a second electrode may be connected to the third node (N3), and a gate electrode may be connected to the second scanning line (GCLi). The third pixel transistor (ST3) may be turned on if a second scanning signal of the turn-on level is supplied to the second scanning line (GCLi), to electrically connect the gate electrode of the first pixel transistor (ST1) to the second electrode. In other words, if the third pixel transistor (ST3) is turned on, the first pixel transistor (ST1) may be connected in the form of a diode.

A first electrode of the fourth pixel transistor (ST4, a gate initialization transistor) may be connected to the first node (N1), a second electrode may be connected to a first initialization voltage line applied with a first initialization voltage (VINT), and a gate electrode may be connected to the third scanning line (GILi). The fourth pixel transistor (ST4) may be turned on if a third scanning signal of the turn-on level is supplied to the third scanning line (GILi), to supply the first initialization voltage (VINT) to the first node (N1).

A first electrode of the fifth pixel transistor (ST5, a first light emitting transistor) may be connected to the first power line applied with the first power voltage (VDD), a second electrode may be connected to the first node (N1), and a gate electrode may be connected to an emission line (EMLi). The fifth pixel transistor (ST5) may be turned off if an emission signal of the turn-off level is supplied to the emission line (EMLi), and may be turned on otherwise.

A first electrode of the sixth pixel transistor (ST6, a second light emitting transistor) may be connected to the third node (N3), a second electrode may be connected to a fourth node (N4), and a gate electrode may be connected to the emission line (EMLi). The sixth pixel transistor (ST6) may be turned off if an emission signal of the turn-off level is supplied to the emission line (EMLi), and may be turned on otherwise. The pixel (PX) may emit light in response to the emission signal received from the emission line (EMLi). In other words, the pixel (PX) may determine the emission timing in response to the emission signal received from the emission line (EMLi).

A first electrode of the seventh pixel transistor (ST7, an anode initialization transistor) may be connected to the fourth node (N4), the second electrode may be connected to a second initialization voltage line applied with a second initialization voltage (AINT), and a gate electrode may be connected to the fourth scanning line (GBLi). The seventh pixel transistor (ST7) may be turned on if a fourth scanning signal of the turn-on level is supplied to the fourth scanning line (GBLi), to supply the second initialization voltage (AINT) to the fourth node (N4). For example, an i-th first scanning line (GBLi) may be the same as an i-1-th first scanning line (GWLi).

A first electrode of the eighth pixel transistor (ST8, a bias transistor) may receive a bias voltage (VOBS), a second electrode may be connected to the second node (N2), and a gate electrode may be connected to the fourth scanning line (GBLi). The eighth pixel transistor (ST8) may be turned on if a fourth scanning signal of the turn-on level is supplied to the fourth scanning line (GBLi), to supply the bias voltage (VOBS) to the second node (N2).

Some transistors (ST1, ST2, ST5, ST6, ST7, ST8) of the pixel transistors (ST1~ST8) may be P-type transistors, and some other transistors (ST3, ST4) may be N-type transistors, which are not limited thereto. For example, each of the pixel transistors (ST1~ST8) may be a P-type transistor or an N-type transistor.

The P-type transistors may be polysilicon semiconductor transistors. The polysilicon semiconductor transistor may include a polysilicon semiconductor in a channels of a semiconductor layer. For example, the polysilicon semiconductor transistor may be a low temperature poly-silicon (LTPS) thin film transistor. The polysilicon semiconductor transistor has high electron mobility, and accordingly has a fast driving characteristic.

The N-type transistors may be oxide semiconductor transistors. The oxide semiconductor transistor may include an oxide semiconductor in the channel of the semiconductor layer. For example, the oxide semiconductor transistor may be a low temperature polycrystalline oxide (LTPO) thin film transistor. The oxide semiconductor transistor has lower charge mobility compared to the polysilicon semiconductor transistor. Hence, the oxide semiconductor transistors have less leakage current than the polysilicon semiconductor transistors in the turn-off state. Hereafter, such explanations are omitted.

A first electrode of the storage capacitor (Cst) may be connected to the first power line applied with the first power voltage (VDD), and a second electrode may be connected to the first node (N1).

An anode electrode of the light emitting element (LD) may be connected to the fourth node (N4), and a cathode electrode may be connected to the second power line applied with the second power voltage (VSS). The light emitting element (LD) may be a light emitting diode. The light emitting element (LD) may include an organic light emitting diode, an inorganic light emitting diode, a quantum dot/well light emitting diode and so on. The light emitting element (LD) may emit light in any one of the first color, the second color, and the third color. In addition, only one light emitting element (LD) is provided in each pixel according to some embodiments, but a plurality of light emitting elements may be provided in each pixel according to some embodiments. In this case, a plurality of light emitting elements may be connected in series, in parallel, or in series and parallel.

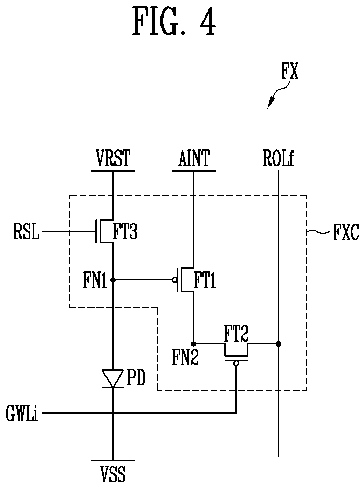

FIG. 4 is a diagram for illustrating an optical sensor according to some embodiments of the present disclosure. Although FIG. 4 illustrates various components in an optical sensor according to some embodiments, embodiments according to the present disclosure are not limited thereto, and according to some embodiments, the optical sensor may include additional components or fewer components without departing from the scope of embodiments according to the present disclosure.

Referring to FIG. 4, the optical sensor (FX) may include a sensor circuit (FXC) and a light receiving element (PD). The sensor circuit (FXC) may include sensing transistors (FT1~FT3). The sensor circuit (FXC) may be connected to an anode electrode of the light receiving element (PD) at a first node (FN1).

A first electrode of a first sensing transistor (FT1, an amplifying transistor) may be connected to a second initialization line applied with the second initialization voltage (AINT), a second electrode may be connected to a second node (FN2), and a gate electrode may be connected to the first node (FN1). The first sensing transistor (FT1) may control a sensing current flowing to the first sensing transistor (FT1) in response to a voltage of the first node (FN1). The sensing current may be supplied to a readout line (ROLf) as a sensing signal via the second sensing transistor (FT2). The first node (FN1) may be referred to as an sensing node.

A first electrode of the second sensing transistor (FT2, an output transistor) may be connected to the second node (FN2), a second electrode may be connected to the readout line (ROLf), and a gate electrode may be connected to the first scanning line (GWLi). In other words, the gate electrode of the second sensing transistor (FT2) and the gate electrode of the second pixel transistor (ST2) may be connected to the same scanning line, that is, the first scanning line (GWLi). The second sensing transistor (FT2) may be turned on if a first scanning signal of the turn-on level is supplied to the first scanning line (GWLi), to electrically connect the second electrode of the first sensing transistor (FT1) and the readout line (ROLf).

A first electrode of a third sensing transistor (FT3, a reset transistor) may be connected to the reset voltage line applied with a reset voltage (VRST), a second electrode may be connected to the first node (FN1), and a gate electrode may be connected to the reset line (RSL). The optical sensor (FX) may reset the voltage of the sensing node (i.e., the first node (FN1)) in response to the reset signal received from the reset line (RSL). The third sensing transistor (FT3) may be turned on if a reset signal of the turn-on level is supplied to the reset line (RSL), to supply the reset voltage (VRST) to the first node (FN1). The gate electrode of the first node (FN1), that is, the first sensing transistor (FT1), may be reset by the reset voltage (VRST). The reset voltage (VRST) may be set to be smaller than the second power voltage (VSS).

Some transistors (FT1, FT2) of the sensing transistors (FT1~FT3) may be P-type transistors, and some other transistor (FT3) may be an N-type transistor, which are not limited thereto. For example, each of the sensing transistors (FT1~FT3) may be a P-type transistor or an N-type transistor.

The first electrode (or, the anode electrode) of the light receiving element (PD) may be connected to the first node (FN1), and the second electrode (or, the cathode electrode) may be connected to a second power line applied with the second power voltage (VSS). The light receiving element (PD) may be a photo diode. However, according to some embodiments, the light receiving element (PD) may include a photo transistor. If the light receiving element (PD) receives light, electrons may be excited, to allow reverse current to flow in a direction from the cathode electrode to the anode electrode. Thus, if the light receiving element (PD) is exposed to light, the voltage of the first node (FN1) may gradually increase after the reset. As the light receiving time increases or the amount of the received light increases, the voltage increase of the first node (FN1) may increase after the reset. Hence, depending on the light receiving time and the amount of the received light, the magnitude of the sensing current flowing through the readout line (ROLf) may differ.

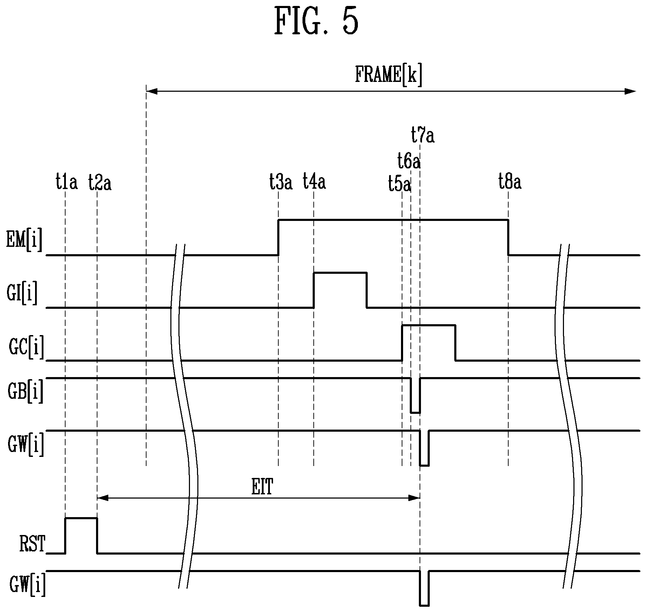

FIG. 5 is a diagram for illustrating a driving method of a pixel and an optical sensor according to some embodiments of the present disclosure.

FIG. 5 describes how the pixel (PX) of FIG. 3 and the optical sensor (FX) of FIG. 4 operate in an arbitrary k-th frame period (FRAME[k]).

First, for a period (t1a~t2a) prior to the k-th frame period (FRAME[k]), the reset signal (RST) of the turn-on level may be applied to the reset line (RSL). Hence, the first node (FN1) of the optical sensor (FX) may be reset by the reset voltage (VRST). After a timing (t2a), the voltage of the first node (FN1) gradually increases according to a length of the light receiving period (EIT) and the amount of light received.

At a timing (t3a), an emission signal (EM[i]) of the turn-off level is fed to the emission line (EMLi). Hence, the fifth pixel transistor (ST5) and the sixth pixel transistor (ST6) are turned off, and the emission of the light emitting element (LD) is prevented or reduced.

At a timing (t4a), a third scanning signal (GI[i]) of the turn-on level is fed to the third scanning line (GILi). Thus, the fourth pixel transistor (ST4) is turned on, and the first node (N1) is initialized with the first initialization voltage (VINT).

At a timing (t5a), a second scanning signal (GC[i]) of the turn-on level is fed to the second scanning line (GCLi). Accordingly, the third pixel transistor (ST3) is turned on, and the first pixel transistor (ST1) is connected to the diode.

At a timing (t6a), a fourth scanning signal (GB[i]) of the turn-on level is fed to the fourth scanning line (GBLi). Hence, the seventh pixel transistor (ST7) is turned on, and the fourth node (N4) is initialized with the second initialization voltage (AINT). The second initialization voltage (AINT) is set to a voltage equal to or lower than the second power voltage (VSS), which may advantage the low-grayscale representation of the light emitting element (LD). In addition, the eighth pixel transistor (ST8) is turned on, and the second node (N2) is initialized with the bias voltage (VOBS).

At a timing (t7a), the first scanning signal (GW[i]) of the turn-on level is fed to the first scanning line (GWLi). Accordingly, the second pixel transistor (ST2) is turned on, and the data voltage is applied to the second node (N2). At this time, the first node (N1) may be applied with the first initialization voltage (VINT), and the first initiation voltage (VINT) may be a voltage sufficiently smaller than data voltages. Thus, the first pixel transistor (ST1) may be turned on, and a compensation data voltage reflecting threshold voltage reduction in the data voltage may be applied to the first node (N1). The storage capacitor (Cst) maintains a voltage corresponding to a difference between the first power voltage (VDD) and the compensation data voltage. This period may be referred to as a threshold voltage compensation period or a data writing period.

In addition, at the timing (t7a), the second sensing transistor (FT2) is turn on by the first scanning signal (GW[i]) of the turn-on level. Thus, a sensing current corresponding to the light receiving period (EIT) and the received light amount may flow to the readout line (ROLf).

At a timing (t8a), the emission signal (EM[i]) of the turn-on level is fed to the emission line (EMLi). Accordingly, the fifth pixel transistor (ST5) and the sixth pixel transistor (ST6) are turned on, and the light emitting element (LD) may emit light.

In so doing, a driving current path is formed connecting the first power line, the fifth pixel transistor (ST5), the first pixel transistor (ST1), the sixth pixel transistor (ST6), the light emitting element (LD), and the second power line. Depending on the voltage maintained in the storage capacitor (Cst), the amount of the driving current flowing to the first electrodes and the second electrode of the first pixel transistor (ST1) is regulated. The light emitting element (LD) emits light with a luminance corresponding to the amount of the driving current. The light emitting element (LD) may emit light until the emission signal (EM[i]) of the turn-off level is applied to the emission line (EMLi).

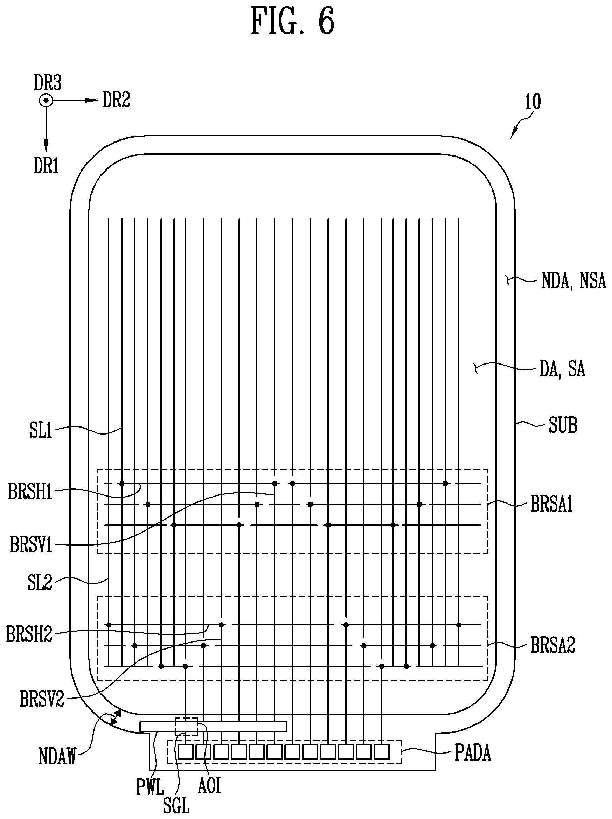

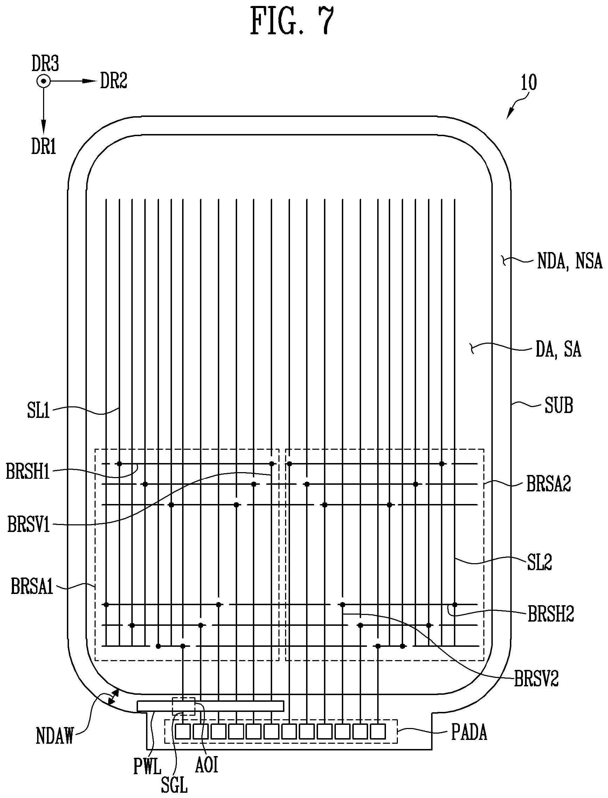

FIG. 6 and FIG. 7 are drawings for illustrating relationship of pads, connection lines, and signal lines according to some embodiments of the present disclosure.

Referring to FIG. 6, a substrate (SUB) of the display panel 10 may include a display area (DA) and a non-display area (NDA). The display area (DA) is an area where the pixels (PX) are positioned, and the non-display area (NDA) may be an area where no pixels (PX) are positioned. In addition, the substrate (SUB) may include a sensing area (SA) and a non-sensing area (NSA). The sensing area (SA) may be an area where optical sensors (FX) are positioned, and the non-sensing area (NSA) may be an area where no optical sensors (FX) are positioned.

For example, a size and a shape of the display area (DA) may be the same as a size and a shape of the sensing area (SA). In addition, a size and a shape of the non-sensing area (NDA) may be the same as a size and a shape of the non-sensing area (NSA). However, according to some embodiments, the sensing area (SA) may be greater or smaller than the display area (DA). Depending on the size of the sensing area (SA), the non-sensing area (NSA) may be smaller or greater than the non-display area (NDA).

Hereinafter, a plane direction of the substrate (SUB) is defined based on the first direction (DR1) and the second direction (DR2) which is perpendicular to the first direction (DR1), and a vertical direction of the substrate (SUB) is defined based on a third direction (DR3). However, this is for ease of explanation, and the substrate (SUB) may be curved. For example, a portion protruding in the first direction (DR1) of the substrate (SUB) includes a pad area (PADA), and the protruding portion may be bent to thus minimize a dead space. In addition, other sides of the substrate (SUB) may be also bent, to realize the display device (DD) including a narrow bezel which minimizes the non-display area (NDA).

The substrate (SUB) may include a first connection area (BRSA1) and a second connection area (BRSA2). The first connection area (BRSA1) and the second connection area (BRSA2) may commonly include signal lines (SL1, SL2) and first connection lines (BRSV1, BRSV2) extending in the first direction (DR1). The first connection area (BRSA1) may include second connection lines (BRSH1) extending in the second direction (DR2). Meanwhile, the second connection area (BRSA2) may include second connection lines (BRSH2) extending in the second direction (DR2).

The signal lines (SL1, SL2) may include the data lines (DL1~DLm) and the readout lines (ROL1~ROLr) (see FIG. 1). The signal lines (SL1, SL2) may be continuously extending in the first direction (DR1) without being disconnected in between.

By contrast, the first connection lines (BRSV1, BRSV2) and the second connection lines (BRSH1, BRSH2) may be disconnected at an intermediate point if required. The first connection lines (BRSV1, BRSV2) and the second connection lines (BRSH1, BRSH2) may transmit signals to the signal lines (SL1, SL2), by connecting with corresponding pads of the pad area (PADA).

The first connection area (BRSA1) may be a readout connection area. For example, the second connection lines (BRSH1) of the first connection area (BRSA1) may be the second readout connection lines connected to the readout lines (ROL1 ~ROLr) of the optical sensors (FX) (see FIG. 1). For example, the first signal lines (SL1) may be the readout lines (ROL1 ~ROLr). In this case, the first connection lines (BRSV1) connected with the second connection lines (BRSH1) in the first connection area (BRSA1) may be the first readout connection lines. One of the readout lines, one of the first readout connection lines, and one of the second readout connection lines may be connected to each other. Their connection orders are irrelevant, and "connected to each other" means connected to "the same electrical node". Wiring connected to the same electrical node may have the same voltage. The first connection lines (BRSV1), which are connected to the corresponding pads, may transmit the sensing currents received from the optical sensors (FX) to an integrated chip (IC) connected to the pads.

In addition, the second connection area (BRSA2) may be a data connection area. For example, the second connection lines (BRSH2) of the second connection area (BRSA2) may be the second data connection lines connected to the data lines (DL1~DLm) of the pixels (PX) (see FIG. 1). For example, the second signal lines (SL2) may be the data lines (DL1~DLm). In this case, the first connection lines (BRSV2) connected to the second connection lines (BRSH2) in the second connection area (BRSA2) may be the first data connection lines. One of the data lines, one of the first data connection lines, and one of the second data connection lines may be connected to each other. Their connection orders are irrelevant, and "connected to each other" means connected to "the same electrical node". Wiring connected to the same electrical node may have the same voltage. The first connection lines (BRSV2), which are connected to the corresponding pads, may transmit the data voltages received from the IC to the pixels (PX).

FIG. 6 have illustrated that the second connection area (BRSA2) is positioned in the first direction (DR1) from the first connection area (BRSA1). However, this is merely an example. As another example, the first connection area (BRSA1) may be configured to be positioned in the first direction (DR1) from the second connection area (BRSA2).

Meanwhile, the first connection area (BRSA1) and the second connection area (BRSA2) do not necessarily have to be spaced apart from each other in the first direction (DR1). Referring to FIG. 7, the first connection area (BRSA1) and the second connection area (BRSA2) may be spaced apart from each other in the second direction (DR2).

In addition, according to some embodiments, there may be no distinction between the first connection area (BRSA1) and the second connection area (BRSA2). For example, by alternately arranging the second readout connection line and the second data connection line in the first direction (DR1), the distinction between the readout connection area and the data connection area may be meaningless.

According to some embodiments, the display device (DD) may further include an additional sensor layer above the layer (i.e., in the third direction (DR3)) in which the pixels (PX) and the optical sensors (FX) are formed. The additional sensor layer is a sensor layer for sensing a user's touch and an active pen, and may be configured in various types such as a resistive type, a capacitive type, an electro-magnetic induction type (EMI), an electro-magnetic resonance type (EMR), and an optical type. According to some embodiments, the additional sensor layer may be positioned below (i.e., in a direction opposite to the third direction (DR3)) the layer in which the pixels (PX) and the optical sensors (FX) are formed.

Meanwhile, the display device (DD) may not include optical sensors (FX). In this case, the first connection area (BRSA1) may not exist, and only the second connection area (BRSA2) may exist. Alternatively, the first connection area (BRSA1) may be used as the data connection area.

Edges of the substrate (SUB) may have an angular shape, but may have a curved shape as shown in FIG. 6. The curved edges make it difficult to implement a fanout structure which is a structure of the connection lines located in the non-display area (NDA).

The first connection area (BRSA1) and the second connection area (BRSA2) according to some embodiments allow a fanout free structure. In other words, because the connection lines located in the non-display area (NDA) are positioned in the first connection area (BRSA1) and the second connection area (BRSA2) within the display area (DA), a width (NDAW) of the non-display area (NDA) may be relatively reduced.

At this time, as the width (NDAW) of the non-display area (NDA) decreases, a width (e.g., a width of the first direction (DR1)) of the power line (PWL) existing in the non-display area (NDA) also needs to be narrowed. However, the power line (PWL) require a wide area to prevent or reduce voltage drop. Thus, the power line (PWL) may be configured to have a vertical stacking structure through a contact hole. In this case, if the signal line (SGL) and the power line (PWL) are positioned to overlap each other, the power line (PWL) may have poor contact depending on the structure of the lower signal line (SGL). In addition, even if the contact is made at the time of manufacturing, a burnt defect may occur in an aging process of testing harsh voltage conditions.

Transistor control signals may be applied to the signal line (SGL). The transistor control signal may be applied to the gate electrode, the source electrode, or the drain electrode of the transistor to thus set a voltage for the control of the transistor (e.g., turning the transistor on or off). For example, the transistor control signal may be the bias voltage (VOBS) shown in FIG. 3. In addition, the transistor control signal may be clock signals, a high voltage signal, or a low voltage signal provided to the scanning driver 30 shown in FIG. 1. The high voltage signal may be used to configure the high level of the scanning signal, and the low voltage signal may be used to configure the low level of the scanning signal. Meanwhile, according to some embodiments, the clock signals provided to the scanning driver 30 may be used to configure the high level or the low level of the scanning signal. In addition, the transistor control signal may be the clock signals, the high voltage signal, or the low voltage signal provided to the emission driver 40 shown in FIG. 1. The high voltage signal may be used to configure the high level of the emission signal, and the low voltage signal may be used to configure the low level of the emission signal. In addition, according to some embodiments, the clock signals provided to the emission driver 40 may be used to configure the high level or the low level of the emission signal.

The signal line (SGL) may cross the display area (DA) and the non-display area (NDA), and may extend in the first direction (DR1). The signal line (SGL) may be connected to the corresponding pad of the pad area (PADA).

The power line (PWL) may be applied with the first power voltage (VDD) or the second power voltage (VSS). Meanwhile, according to some embodiments, the power line (PWL) may be applied with the first initialization voltage (VINT) or the second initialization voltage (AINT). The signals applied to the power line (PWL) may require a greater current than the signals applied to the signal line (SGL). For example, the signals applied to the power line (PWL) may be used to set the voltage of the capacitor (Cst) or the light emitting element (LD).

The power line (PWL) may overlap with the signal line (SGL) in the non-display area (NDA), and may extend in the second direction (DR2) which is different from the first direction (DR1). The power line (PWL) may be connected to the corresponding pad of the pad area (PADA). In another example, the power line (PWL) may be connected to a corresponding pad positioned outside the pad area (PADA).

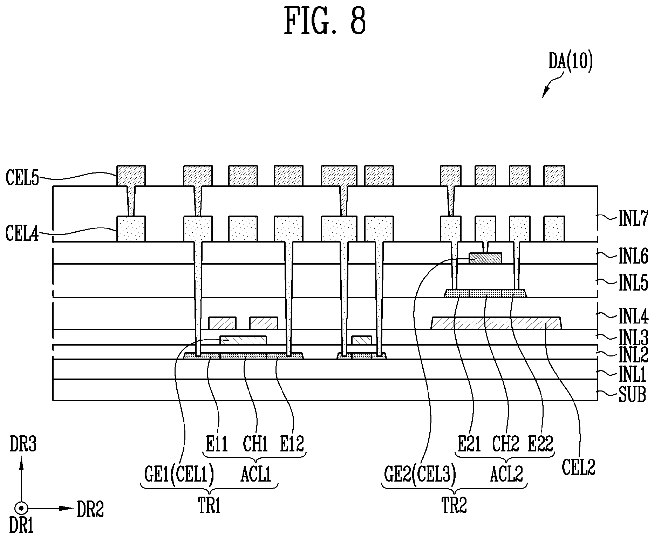

FIG. 8 is a diagram for illustrating a stacking structure of a display area of a display panel.

Referring to FIG. 8, the display panel 10 may have a structure in which a substrate (SUB), a first insulation layer (INL1), a first active layer (ACL1), a second insulation layer (INL2), a first electrode layer (CEL1), a third insulation layer (INL3), a second electrode layer (CEL2), a fourth insulation layer (INL4), a second active layer (ACL2), a fifth insulation layer (INL5), a third electrode layer (CEL3), a sixth insulation layer (INL6), a fourth electrode layer (CEL4), a seventh insulation layer (INL7), and a fifth electrode layer (CEL5) are stacked sequentially.

FIG. 8 illustrates the stacking structure of the pixel circuit (PXC) or the sensor circuit (FXC) of the display area (DA) or the sensing area (SA). The stacking structure of the light emitting element (LD) or the light receiving element (PD) may use a conventional known technology.

The substrate (SUB) may be formed of various materials such as glass, polymer, and metal. The substrate (SUB) may be selected as one of a rigid substrate or a flexible substrate, depending on an application product. If the substrate (SUB) is configured to include a polymeric organic material, the substrate (SUB) may include polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, cellulose acetate propionate, and so on. By contrast, the substrate (SUB) may be formed of glass, fiberglass reinforced plastic (FRP), and the like.

The first active layer (ACL1) and the second active layer (ACL2) may be semiconductor layers. For example, the first active layer (ACL1) may include a polysilicon semiconductor, and the second active layer (ACL2) may include an oxide semiconductor. The first active layer (ACL1) may include a channel (CH1), a first electrode (E11), and a second electrode (E12) of polysilicon semiconductor transistors (TR1: ST1, ST2, ST5, ST6, ST7, ST8, FT1, FT2). The second active layer (ACL2) may include a channel (CH2), a first electrode (E21), and a second electrode (E22) of oxide semiconductor transistors (TR2: ST3, ST4, FT3). The first electrode and the second electrode of each of the transistors may be doped with impurities for conducting.

The gate electrode (GE1) of the polysilicon semiconductor transistor (TR1) may be positioned in the first electrode layer (CEL1). According to some embodiments, a sub gate electrode (or, a backgate electrode, a body electrode) of the polysilicon semiconductor transistor (TR1) may be positioned between the substrate (SUB) and the first insulation layer (INL1).

The gate electrode (GE2) of the oxide semiconductor transistor (TR2) may be positioned in the third electrode layer (CEL3). According to some embodiments, a sub gate electrode (or, a backgate electrode, a body electrode) of the oxide semiconductor transistor (TR2) may be positioned in the second electrode layer (CEL2).

The first electrode layer (CEL1), the second electrode layer (CEL2), the third electrode layer (CEL3), the fourth electrode layer (CEL4), and the fifth electrode layer (CEL5) may be conductor layers. Each electrode layer may include a single layer or a multi-layer, and may be configured using a well-known conductive material such as gold (Au), silver (Ag), aluminum (Al), molybdenum (Mo), chromium (Cr), titanium (Ti), nickel (Ni), neodymium (Nd), copper (Cu), or platinum (Pt).

The first insulation layer (INL1), the second insulation layer (INL2), the third insulation layer (INL3), the fourth insulation layer (INL4), the fifth insulation layer (INL5), the sixth insulation layer (INL6), and the seventh insulation layer (INL7) may be interposed to electrically separate the active layers (ACL1, ACL2) and the first through fifth electrode layers (CEL1, CEL2, CEL3, CEL4, CEL5). Required electrode patterns may be connected to each other through a contact hole formed in each insulation layer (INL1~INL7). The insulation layers (INL1~INL7) may include an organic insulating film, an inorganic insulating film, or an organic/inorganic insulating film, may include a single layer, and may include a multi-layer. For example, the insulation layers (INL1~INL7) may include at least one of silicon nitride (SiNx), silicon oxide (SiOx), silicon nitride (SiOxNy), acryl resin, epoxy resin, phenolic resin, polyamide resin, or polyimide resin.

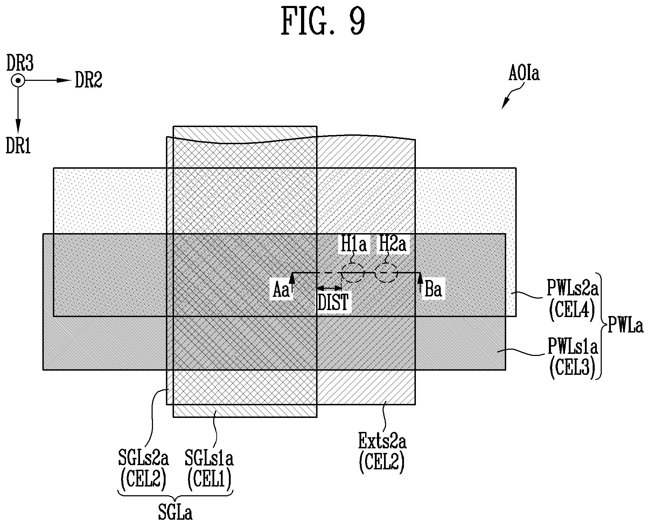

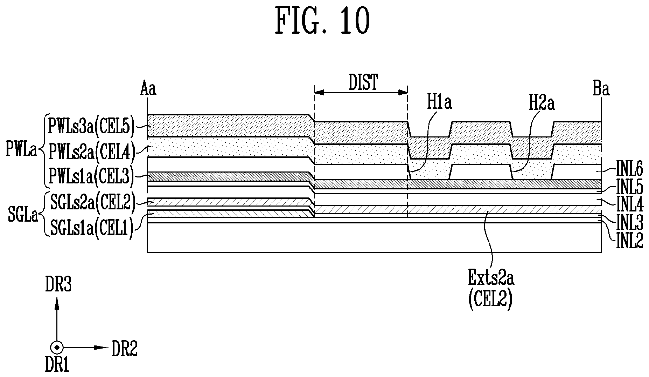

FIG. 9 is a plan view of an area of interest according to some embodiments of the present disclosure. FIG. 10 is a cross-sectional diagram along a line Aa-Ba of the area of interest of FIG. 9.

Hereafter, embodiments of the area of interest (AOI) of FIG. 6 or FIG. 7 are described, by referring to FIG. 9 through FIG. 29.

Referring to FIG. 9, a signal line (SGLa) and a power line (PWLa) may be positioned in an area of interest (AOIa).

The signal line (SGLa) may include a first sub signal line (SGLs1a) and a second sub signal line (SGLs2a). The first electrode layer (CEL1) may include the first sub signal line (SGLs1a). The second electrode layer (CEL2) may include the second sub signal line (SGLs2a).

The first sub signal line (SGLs1a) and the second sub signal line (SGLs2a) may be connected to each other through a contact hole or an etched portion, to have the same potential. According to some embodiments, the first sub signal line (SGLs1a) and the second sub signal line (SGLs2a) may be separated and used to transmit different signals.

The power line (PWLa) may include a first sub power line (PWLs1a) and a second sub power line (PWLs2a) connected through a first contact hole (H1a). The third electrode layer (CEL3) may include the first sub power line (PWLs1a). The fourth electrode layer (CEL4) may include the second sub power line (PWLs2a).

The first contact hole (H1a) may be spaced apart in the second direction (DR2) from an overlapping area of the first sub signal line (SGLs1a) and the second sub signal line (SGLs2a). Referring to FIG. 10, the first sub signal line (SGLs1a) and the second sub signal line (SGLs2a) form a slope at a boundary of the overlapping area. According to some embodiments of the present disclosure, the first contact hole (H1a) may be formed by spacing over a specific distance (DIST) from such a slope. For example, the specific distance (DIST) may be 2 micrometers. According to experimental results, a burnt defect rate measured at the specific distance (DIST) of 1.5 micrometers was 2.13%, and the burnt defect rate measured at the specific distance (DIST) of 2 micrometers was 1.07%. In other words, according to some embodiments, the burnt defect rate may be reduced by 2 times (or about 2 times). According to some embodiments, even if the signal line (SGLa) and the power line (PWLa) are positioned to overlap each other, a contact failure or a burnt defect may be prevented or reduced.

According to some embodiments, the second sub signal line (SGLs2a) may include an extension extending in the second direction (DR2). At this time, the first contact hole (H1a) may be positioned on the extension (Exts2a). According to some embodiments, a gradient of the slope may be relatively reduced. Thus, the contact failure rate or the burnt defect rate may be further reduced.

According to some embodiments, the first sub power line (PWLs1a) and the second sub power line (PWLs2a) each may extend in the second direction (DR2). At this time, the first sub power line (PWLs1a) and the second sub power line (PWLs2a) may be further connected through a second contact hole (H2a) positioned in the second direction (DR2) from the first contact hole (H1a). According to some embodiments, even if a contact failure or a burnt defect occurs in the first contact hole

(H1a), the first sub power line (PWLs1a) and the second sub power line (PWLs2a) may be connected to each other by maintaining contact in the second contact hole (H2a) which is more stable. In addition, if there occur no failures in both the first contact hole (H1a) and the second contact hole (H2a), the voltage drop of the power line (PWLa) may be relatively reduced more effectively.

Refer to FIG. 10, the power line (PWLa) may further include a third sub power line (PWLs3a). The fifth electrode layer (CEL5) may include the third sub power line (PWLs3a). By removing an insulation layer between the second sub power line (PWLs2a) and the third sub power line (PWLs3a), the voltage drop of the power line (PWLa) may be reduced more effectively.

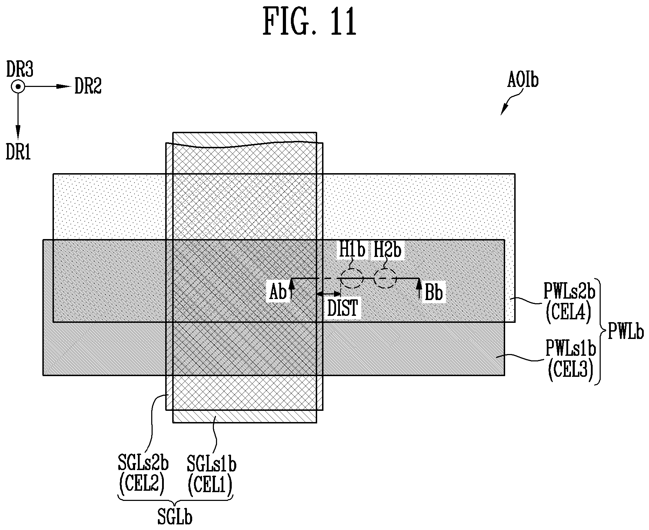

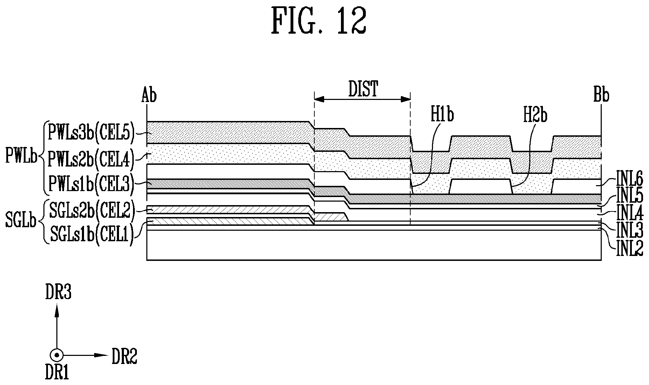

FIG. 11 is a plan view of an area of interest according to some embodiments of the present disclosure. FIG. 12 is a cross-sectional diagram along a line Ab-Bb of the area of interest of FIG. 11.

Referring to FIG. 11, a signal line (SGLb) and a power line (PWLb) may be positioned in an area of interest (AOIb).

The signal line (SGLb) may include a first sub signal line (SGLs1b) and a second sub signal line (SGLs2b). The first electrode layer (CEL1) may include the first sub signal line (SGLs1b). The second electrode layer (CEL2) may include the second sub signal line (SGLs2b).

The first sub signal line (SGLs1b) and the second sub signal line (SGLs2b) may be connected to each other through a contact hole or an etched portion, to have the same potential. According to some embodiments, the first sub signal line (SGLs1b) and the second sub signal line (SGLs2b) may be separated and used to transmit different signals.

The power line (PWLb) may include a first sub power line (PWLs1b) and a second sub power line (PWLs2b) connected through a first contact hole (H1b). The third electrode layer (CEL3) may include the first sub power line (PWLs1b). The fourth electrode layer (CEL4) may include the second sub power line (PWLs2b).

The first contact hole (H1b) may be spaced apart in the second direction (DR2) from an overlapping area of the first sub signal line (SGLs1b) and the second sub signal line (SGLs2b). Referring to FIG. 12, the first sub signal line (SGLs1b) and the second sub signal line (SGLs2b) form a slope at a boundary of the overlapping area. According to some embodiments of the present disclosure, the first contact hole (H1b) may be formed away from this slope by a specific distance (DIST) or more. For example, the specific distance (DIST) may be 2 micrometers. According to experimental results, the burnt defect rate measured at the specific distance (DIST) of 1.5 micrometers was 2.13%, and the burnt defect rate measured at the specific distance (DIST) of 2 micrometers was 1.07%. In other words, according to some embodiments, the burnt defect rate may be reduced by 2 times (or about 2 times). According to some embodiments, even if the signal line (SGLb) and the power line (PWLb) are positioned to overlap each other, a poor contact or a burnt defect may be prevented or reduced.

Unlike the second sub signal line (SGLs2a) of FIG. 9 and FIG. 10, the second sub signal line (SGLs2b) may not include an extension according to some embodiments. In other words, the first contact hole (H1b) may overlap with neither the first sub signal line (SGLs1b) nor the second sub signal line (SGLs2b).

According to some embodiments, the first sub power line (PWLs1b) and the second sub power line (PWLs2b) each may extend in the second direction (DR2). At this time, the first sub power line (PWLs1b) and the second sub power line (PWLs2b) may be further connected through a second contact hole (H2b) positioned in the second direction (DR2) from the first contact hole (H1b). According to some embodiments, even if a contact failure or a burnt defect occurs in the first contact hole (H1b), the first sub power line (PWLs1b) and the second sub power line (PWLs2b) may be connected to each other by maintaining the contact in the second contact hole (H2b) which is more stable. In addition, if there is no failure in both the first contact hole (H1b) and the second contact hole (H2b), the voltage drop of the power line (PWLb) may be reduced more effectively.

Referring to FIG. 12, the power line (PWLb) may further include a third sub power line (PWLs3b). The fifth electrode layer (CEL5) may include the third sub power line (PWLs3b). By removing an insulation layer between the second sub power line (PWLs2b) and the third sub power line (PWLs3b), the voltage drop of the power line (PWLb) may be reduced more effectively.

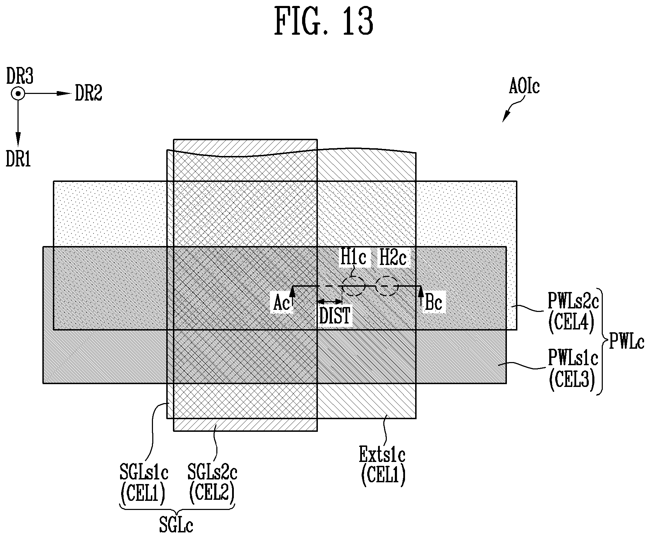

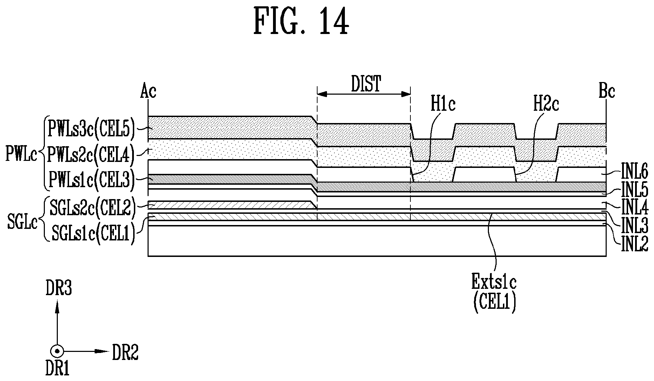

FIG. 13 is a plan view of an area of interest according to some embodiments of the present disclosure. FIG. 14 is a cross-sectional diagram along a line Ac-Bc of the area of interest of FIG. 13.

Referring to FIG. 13, a signal line (SGLc) and a power line (PWLc) may be positioned in an area of interest (AOIc).

The signal line (SGLc) may include a first sub signal line (SGLs1c) and a second sub signal line (SGLs2c). The first electrode layer (CEL1) may include the first sub signal line (SGLs1c). The second electrode layer (CEL2) may include the second sub signal line (SGLs2c).

The first sub signal line (SGLs1c) and the second sub signal line (SGLs2c) may be connected to each other through a contact hole or an etched portion, to have the same potential. According to some embodiments, the first sub signal line (SGLs1c) and the second sub signal line (SGLs2c) may be separated and used to transmit different signals.

The power line (PWLc) may include a first sub power line (PWLs1c) and a second sub power line (PWLs2c) connected through a first contact hole (H1c). The third electrode layer (CEL3) may include the first sub power line (PWLs1c). The fourth electrode layer (CEL4) may include the second sub power line (PWLs2c).

The first contact hole (H1c) may be spaced apart in the second direction (DR2) from an overlapping area of the first sub signal line (SGLs1c) and the second sub signal line (SGLs2c). Referring to FIG. 14, the first sub signal line (SGLs1c) and the second sub signal line (SGLs2c) form a slope at a boundary of the overlapping area. According to some embodiments of the present disclosure, the first contact hole (H1c) may be formed by spacing away from the slope by a specific distance (DIST) or more. For example, the specific distance (DIST) may be 2 micrometers. According to experimental results, the burnt defect rate measured at the specific distance (DIST) of 1.5 micrometers was 2.13%, and the burnt defect rate measured at the specific distance (DIST) of 2 micrometers was 1.07%. In other words, according to some embodiments, the burnt defect rate may be reduced by 2 times (or about 2 times). According to some embodiments, even if the signal line (SGLc) and the power line (PWLc) are positioned to overlap each other, a contact failure or a burnt defect may be prevented or reduced.

According to some embodiments, the first sub signal line (SGLs1c) may include an extension (Exts1c) extending in the second direction (DR2). At this time, the first contact hole (H1c) may be positioned on the extension (Exts1c). According to some embodiments, a gradient of the slope may be relatively reduced Thus, the contact failure rate or the burnt defect rate may be further reduced.

According to some embodiments, the first sub power line (PWLs1c) and the second sub power line (PWLs2c) each may extend in the second direction (DR2). At this time, the first sub power line (PWLs1c) and the second sub power line (PWLs2c) may be further connected through a second contact hole (H2c) positioned in the second direction (DR2) from the first contact hole (H1c). According to some embodiments, even if a contact failure or a burnt defect occurs in the first contact hole (H1c), the first sub power line (PWLs1c) and the second sub power line (PWLs2c) may be connected to each other by maintaining contact in the second contact hole (H2c) which is more stable. In addition, if there is no failure in both the first contact hole (H1c) and the second contact hole (H2c), the voltage drop of the power line (PWLc) may be reduced more effectively.

Referring to FIG. 14, the power line (PWLc) may further include a third sub power line (PWLs3c). The fifth electrode layer (CEL5) may include the third sub power line (PWLs3c). By removing an insulation layer between the second sub power line (PWLs2c) and the third sub power line (PWLs3c), the voltage drop of the power line (PWLc) may be reduced more effectively.

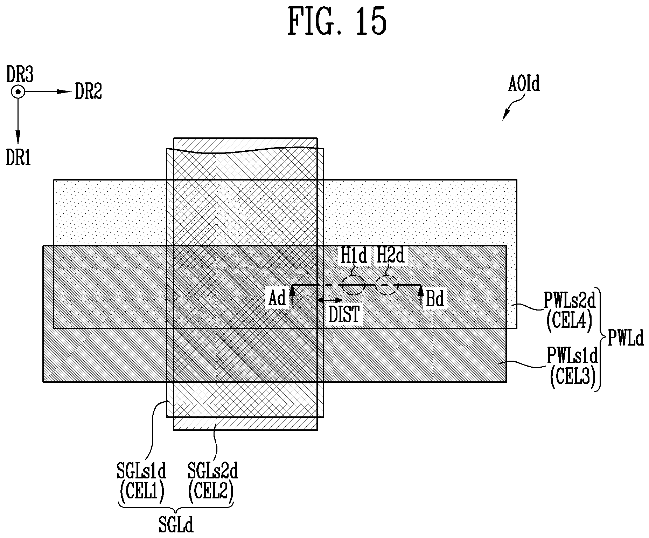

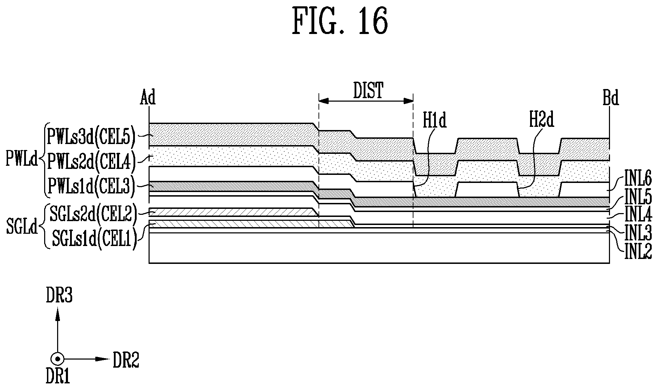

FIG. 15 is a plan view of an area of interest according to some embodiments of the present disclosure. FIG. 16 is a cross-sectional diagram along a line Ad-Bd of the area of interest of FIG. 15.

Referring to FIG. 15, a signal line (SGLd) and a power line (PWLd) may be positioned in an area of interest (AOId).

The signal line (SGLd) may include a first sub signal line (SGLs1d) and a second sub signal line (SGLs2d). The first electrode layer (CEL1) may include the first sub signal line (SGLs1d). The second electrode layer (CEL2) may include the second sub signal line (SGLs2d).

The first sub signal line (SGLs1d) and the second sub signal line (SGLs2d) may be connected to each other through a contact hole or an etched portion, to have the same potential. According to some embodiments, the first sub signal line (SGLs1d) and the second sub signal line (SGLs2d) may be separated and used to transmit different signals.

The power line (PWLd) may include a first sub power line (PWLs1d) and a second sub power line (PWLs2d) connected through a first contact hole (H1d). The third electrode layer (CEL3) may include the first sub power line (PWLs1d). The fourth electrode layer (CEL4) may include the second sub power line (PWLs2d).

The first contact hole (H1d) may be spaced apart in the second direction (DR2) from an overlapping area of the first sub signal line (SGLs1d) and the second sub signal line (SGLs2d). Referring to FIG. 16, the first sub signal line (SGLs1d) and the second sub signal line (SGLs2d) form a slope at a boundary of the overlapping area. According to some embodiments of the present disclosure, the first contact hole (H1d) may be formed by spacing away from the slope by a specific distance (DIST) or more. For example, the specific distance (DIST) may be 2 micrometers. According to experimental results, the burnt defect rate measured at the specific distance (DIST) of 1.5 micrometers was 2.13%, and the burnt defect rate measured at the specific distance (DIST) of 2 micrometers was 1.07%. In other words, according to some embodiments, the burnt defect rate may be reduced by 2 times (or about 2 times). According to some embodiments, even if the signal line (SGLd) and the power line (PWLd) are positioned to overlap each other, a contact failure or a burnt defect may be prevented or reduced.

Unlike the first sub signal line (SGLs1c) of FIG. 13 and FIG. 14, the first sub signal line (SGLs1d) may not include an extension according to some embodiments.

In other words, the first contact hole (H1d) may overlap neither the first sub signal line (SGLs1d) nor the second sub signal line (SGLs2d).

According to some embodiments, the first sub power line (PWLs1d) and the second sub power line (PWLs2d) each may extend in the second direction (DR2). At this time, the first sub power line (PWLs1d) and the second sub power line (PWLs2d) may be further connected through a second contact hole (H2d) positioned in the second direction (DR2) from the first contact hole (H1d). According to some embodiments, even if a contact failure or a burnt defect occurs in the first contact hole (H1d), the first sub power line (PWLs1d) and the second sub power line (PWLs2d) may be connected to each other by maintaining contact in the second contact hole (H2d) which is more stable. In addition, if there is no defect in both the first contact hole (H1d) and the second contact hole (H2d), the voltage drop of the power line (PWLd) may be reduced more effectively.

Referring to FIG. 16, the power line (PWLd) may further include a third sub power line (PWLs3d). The fifth electrode layer (CEL5) may include the third sub power line (PWLs3d). By removing an insulation layer between the second sub power line (PWLs2d) and the third sub power line (PWLs3d), the voltage drop of the power line (PWLd) may be reduced more effectively.

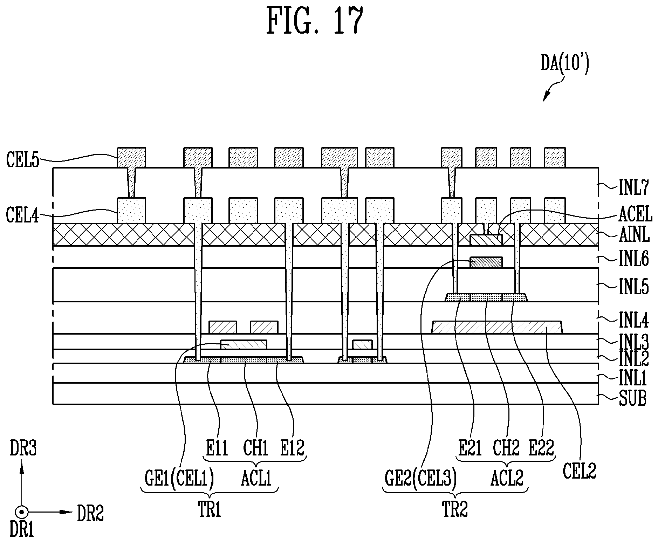

FIG. 17 is a diagram for illustrating a stacking structure of a display area of a display panel according to some embodiments.

A display panel 10' of FIG. 17 may further include an additional electrode layer (ACEL) and an additional insulation layer (AINL), compared to the display panel 10 of FIG. 8. The additional electrode layer (ACEL) may be positioned on the sixth insulation layer (INL6). The additional insulation layer (AINL) may cover the additional electrode layer (ACEL) and the sixth insulation layer (INL6). The fourth electrode layer (CEL4) may be positioned on the additional insulation layer (AINL).

Descriptions on other electrode layers and insulation layers refer to the descriptions in FIG. 8.

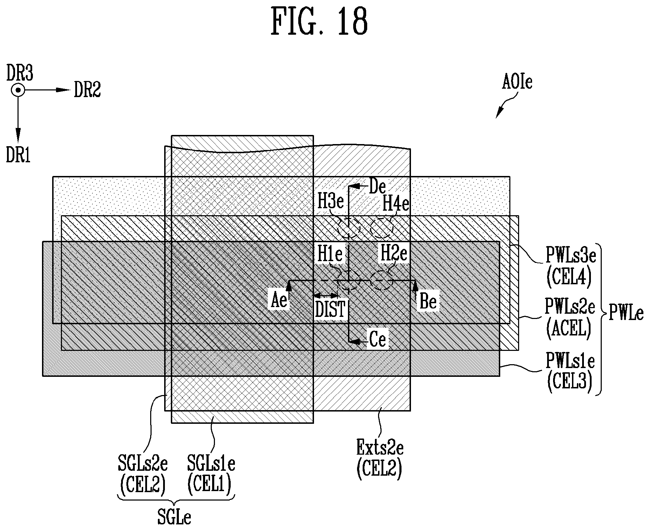

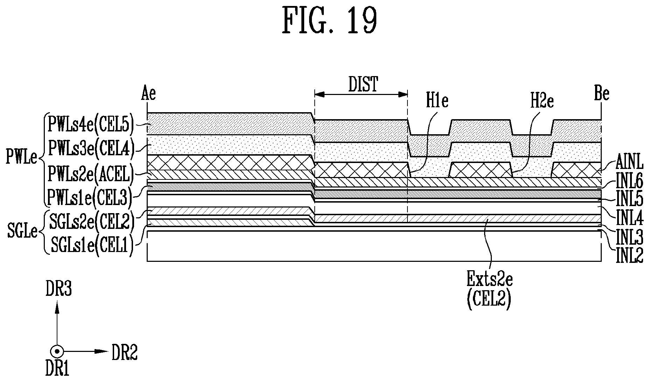

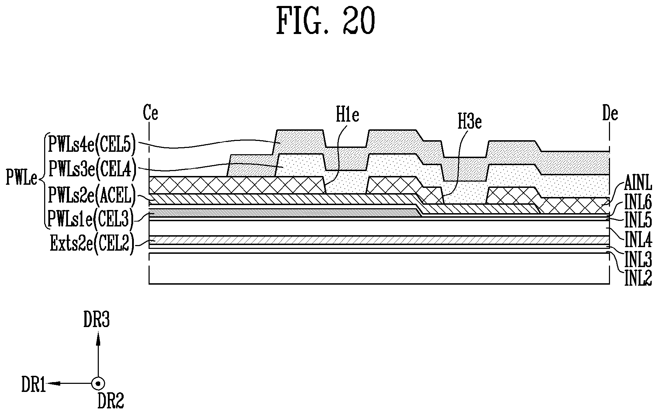

FIG. 18 is a plan view of an area of interest according to some embodiments of the present disclosure. FIG. 19 is a cross-sectional diagram along a line Ae-Be of the area of interest of FIG. 18. FIG. 20 is a cross-sectional diagram along a line Ce-De of the area of interest of FIG. 18.

Referring to FIG. 18, a signal line (SGLe) and a power line (PWLe) may be positioned in an area of interest (AOIe).

The signal line (SGLe) may include a first sub signal line (SGLs1e) and a second-sub signal line (SGLs2e). The first electrode layer (CEL1) may include the first sub signal line (SGLs1e). The second electrode layer (CEL2) may include the second sub signal line (SGLs2e).

The first sub signal line (SGLs1e) and the second sub signal line (SGLs2e) may be connected to each other through a contact hole or an etched portion, to have the same potential. According to some embodiments, the first sub signal line (SGLs1e) and the second sub signal line (SGLs2e) may be separated and used to transmit different signals.

The power line (PWLe) may include a first sub power line (PWLs1e), a second sub power line (PWLs2e), and a third sub power line (PWLs3e) connected with the second sub power line (PWLs2e) through a first contact hole (H1e). The third electrode layer (CEL3) may include the first sub power line (PWLs1e). The additional electrode layer (ACEL) may include the second sub power line (PWLs2e). The fourth electrode layer (CEL4) may include the third sub power line (PWLs3e).

The first sub power line (PWLs1e) and the second sub power line (PWLs2e) may be connected to each other through a contact hole or an etched portion, to have the same potential. According to some embodiments, the first sub power line (PWLs1e) and the second sub power line (PWLs2e) may not be directly connected to each other, but may be capacitively coupled.

The first contact hole (H1e) may be spaced apart in the second direction (DR2) from an overlapping area of the first sub signal line (SGLs1e) and the second sub signal line (SGLs2e). Referring to FIG. 19, the first sub signal line (SGLs1e) and the second sub signal line (SGLs2e) form a slope at a boundary of the overlapping area. According to some embodiments of the present disclosure, a first contact hole (H1e) may be formed apart from the slope by a specific distance (DIST) or more. For example, the specific distance (DIST) may be 2 micrometers. According to experimental results, the burnt defect rate measured at the specific distance (DIST) of 1.5 micrometers was 2.13%, and the burnt defect rate measured at the specific distance (DIST) of 2 micrometers was 1.07%. In other words, according to some embodiments, the burnt defect rate may be reduced by 2 times (or about 2 times). According to some embodiments, even if the signal line (SGLe) and the power line (PWLe) are positioned to overlap each other, a contact failure or a burnt defect may be prevented or reduced.

According to some embodiments, the second sub signal line (SGLs2e) may include an extension (Exts2e) extending in the second direction (DR2). At this time, the first contact hole (H1e) may be positioned on the extension (Exts2e). According to some embodiments, the gradient of the slope is relatively reduced. Thus, the contact failure rate or the burnt defect rate may be further reduced.

According to some embodiments, the first sub power line (PWLs1e), the second sub power line (PWLs2e), and the third sub power line (PWLs3e) each may extend in the second direction (DR2). At this time, the second sub power line (PWLs2e) and the third sub power line (PWLs3e) may be further connected through a second contact hole (H2e) positioned in the second direction (DR2) from the first contact hole (H1e). According to some embodiments, even if a contact failure or a burnt defect occurs in the first contact hole (H1e), the second sub power line (PWLs2e) and the third sub power line (PWLs3e) may be connected to each other by maintaining contact in the second contact hole (H2e) which is more stable. In addition, if there is no failure in both the first contact hole (H1e) and the second contact hole (H2e), the voltage drop of the power line (PWLe) may be reduced more effectively.

Referring to FIG. 19 and FIG. 20, the power line (PWLe) may further include a fourth sub power line (PWLs4e). The fifth electrode layer (CEL5) may include the fourth sub power line (PWLs4e). By removing an insulation layer between the third sub power line (PWLs3e) and the fourth sub power line (PWLs4e), the voltage drop of the power line (PWLe) may be reduced more effectively.

The second sub power line (PWLs2e) and the third sub power line (PWLs3e) may be further connected through a third contact hole (H3e) positioned in a direction opposite to the first direction (DR1) from the first contact hole (H1e). For example, the third contact hole (H3e) may not overlap with the first sub power line (PWLs1e). In addition, the second sub power line (PWLs2e) and the third sub power line (PWLs3e) may be further connected through a fourth contact hole (H4e) positioned in the second direction (DR2) from the third contact hole (H3e). For example, the fourth contact hole (H4e) may not overlap with the first sub power line (PWLs1e). According to some embodiments, the voltage drop of the power line (PWLe) may be reduced more effectively.

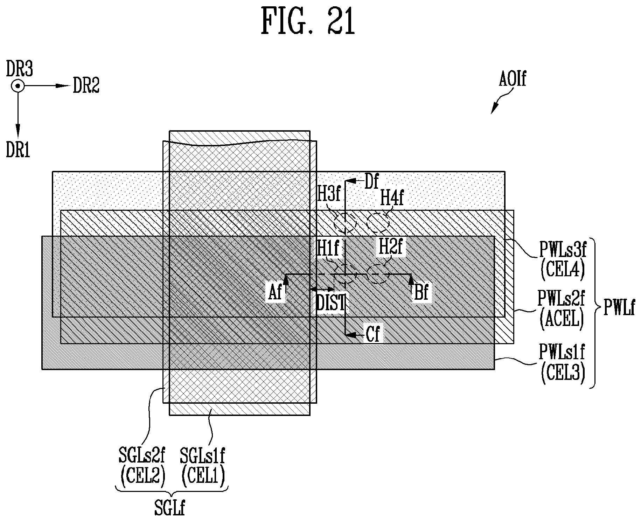

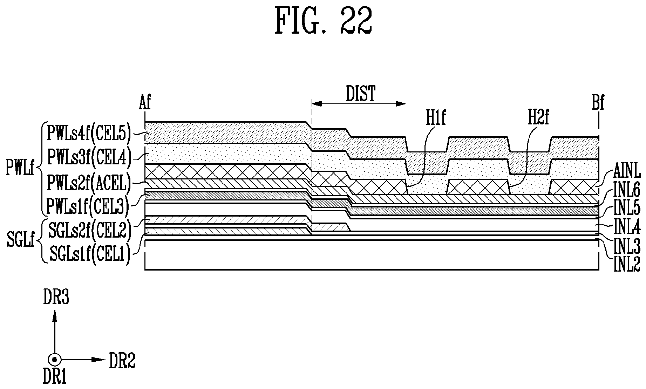

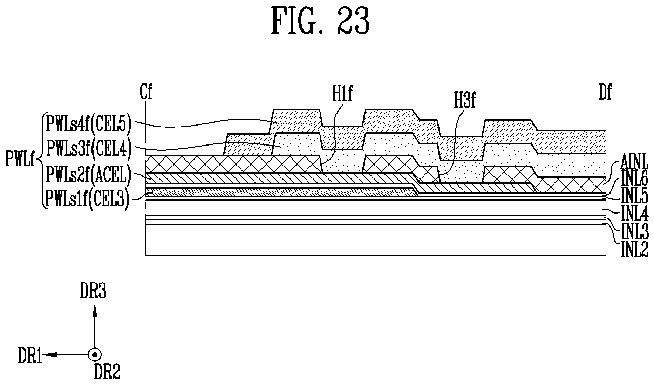

FIG. 21 is a plan view of an area of interest according to some embodiments of the present disclosure. FIG. 22 is a cross-sectional diagram along a line Af-Bf of the area of interest of FIG. 21. FIG. 23 is a cross-sectional diagram along a line Cf-Df of the area of interest of FIG. 21.

Referring to FIG. 21, a signal line (SGLf) and a power line (PWLf) may be positioned in an area of interest (AOIf).

The signal line (SGLf) may include a first sub signal line (SGLs1f) and a second sub signal line (SGLs2f). The first electrode layer (CEL1) may include the first sub signal line (SGLs1f). The second electrode layer (CEL2) may include the second sub signal line (SGLs2f).

The first sub signal line (SGLs1f) and the second sub signal line (SGLs2f) may be connected to each other through a contact hole or an etched portion, to have the same potential. According to some embodiments, the first sub signal line (SGLs1f) and the second sub signal line (SGLs2f) may be separated and used to transmit different signals.

The power line (PWLf) may include a first sub power line (PWLs1f), a second sub power line (PWLs2f), and a third sub power line (PWLs3f) connected to the second sub power line (PWLs2f) through a first contact hole (H1f). The third electrode layer (CEL3) may include the first sub power line (PWLs1f). The additional electrode layer (ACEL) may include the second sub power line (PWLs2f). The fourth electrode layer (CEL4) may include the third sub power line (PWLs3f).

The first sub power line (PWLs1f) and the second sub power line (PWLs2f) may be connected to each other through a contact hole or an etched portion, to have the same potential. According to some embodiments, the first sub power line (PWLs1f) and the second sub power line (PWLs2f) may not be directly connected to each other, but may be capacitively coupled.

The first contact hole (H1f) may be spaced apart in the second direction (DR2) from an overlapping area of the first sub signal line (SGLs1f) and the second sub signal line (SGLs2f). Referring to FIG. 22, the first sub signal line (SGLs1f) and the second sub signal line (SGLs2f) form a slope at a boundary of the overlapping area. According to some embodiments of the present disclosure, the first contact hole (H1f) may be formed apart from such a slope by a specific distance (DIST) or more. For example, the specific distance (DIST) may be 2 micrometers. According to experimental results, the burnt defect rate measured at the specific distance (DIST) of 1.5 micrometers was 2.13%, and the burnt defect rate measured at the specific distance (DIST) of 2 micrometers was 1.07%. In other words, according to some embodiments, the burnt defect rate may be reduced by 2 times (or about 2 times). According to some embodiments, even if the signal line (SGLf) and the power line (PWLf) are positioned to overlap each other, a contact failure or a burnt defect may be prevented or reduced.

Unlike the second sub signal line (SGLs2e) of FIG. 18 through FIG. 20, the second sub signal line (SGLs2f) may not include an extension according to some embodiments. In other words, the first contact hole (H1f) may overlap with neither the first sub signal line (SGLs1f) nor the second sub signal line (SGLs2f).

According to some embodiments, each of the first sub power line (PWLs1f), the second sub power line (PWLs2f), and the third sub power line (PWLs3f) may extend in the second direction (DR2). At this time, the second sub power line (PWLs2f) and the third sub power line (PWLs3f) may be further connected through a second contact hole (H2f) positioned in the second direction (DR2) from the first contact hole (H1f). According to some embodiments, even if a contact failure or a burnt defect occurs in the first contact hole (H1f), the second sub power line (PWLs2f) and the third sub power line (PWLs3f) may be connected to each other by maintaining contact in the second contact hole (H2f) which is more stable. In addition, if there is no failure in both the first contact hole (H1f) and the second contact hole (H2f), the voltage drop of the power line (PWLf) may be reduced more effectively.

Referring to FIG. 22 and FIG. 23, the power line (PWLf) may further include a fourth sub power line (PWLs4f). The fifth electrode layer (CEL5) may include the fourth sub power line (PWLs4f). By removing an insulation layer between the third sub power line (PWLs3f) and the fourth sub power line (PWLs4f), the voltage drop of the power line (PWLf) may be reduced more effectively.

The second sub power line (PWLs2f) and the third sub power line (PWLs3f) may be further connected through a third contact hole (H3f) positioned in the opposite direction of the first direction (DR1) from the first contact hole (H1f). For example, the third contact hole (H3f) may not overlap with the first sub power line (PWLs1f). In addition, the second sub power line (PWLs2f) and the third sub power line (PWLs3f) may be further connected through a fourth contact hole (H4f) positioned in the second direction (DR2) from the third contact hole (H3f). For example, the fourth contact hole (H4f) may not overlap with the first sub power line (PWLs1f). According to some embodiments, the voltage drop of the power line (PWLf) may be reduced more effectively.

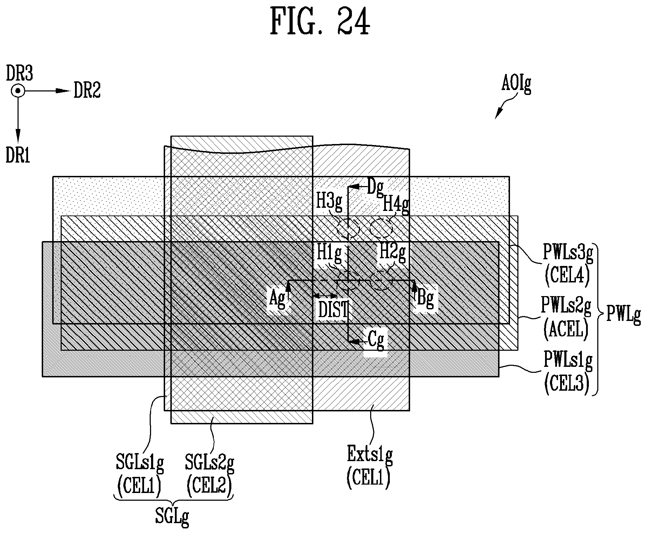

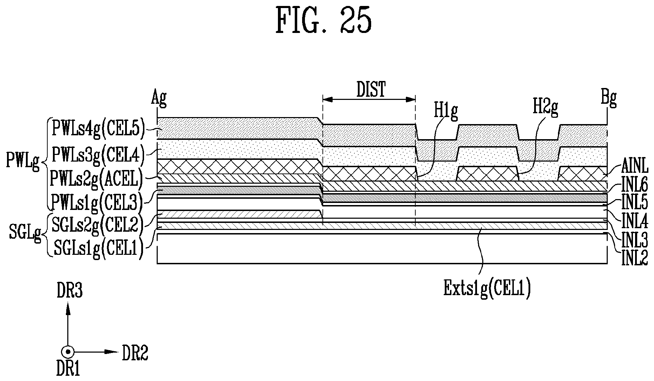

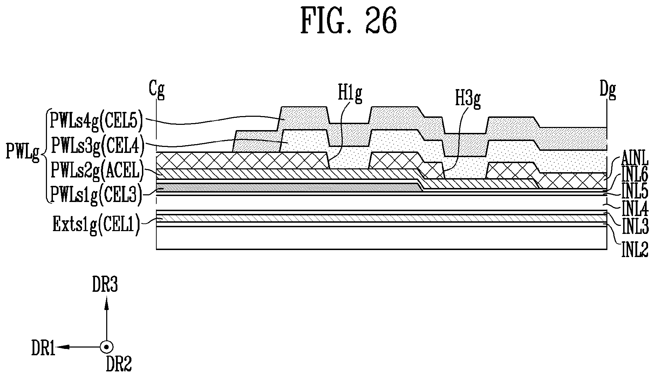

FIG. 24 is a plan view of an area of interest according to some embodiments of the present disclosure. FIG. 25 is a cross-sectional diagram along a line Ag-Bg of the area of interest of FIG. 24. FIG. 26 is a cross-sectional diagram along a line Cg-Dg of the area of interest of FIG. 24.

Referring to FIG. 24, a signal line (SGLg) and a power line (PWLg) may be positioned in an area of interest (AOIg).

The signal line (SGLg) may include a first sub signal line (SGLs1g) and a second sub signal line (SGLs2g). The first electrode layer (CEL1) may include the first sub signal line (SGLs1g). The second electrode layer (CEL2) may include the second sub signal line (SGLs2g).

The first sub signal line (SGLs1g) and the second sub signal line (SGLs2g) may be connected to each other through a contact hole or an etched portion, to have the same potential. According to some embodiments, the first sub signal line (SGLs1g) and the second sub signal line (SGLs2g) may be separated and used to transmit different signals.

The power line (PWLg) may include a first sub power line (PWLs1g), a second sub power line (PWLs2g), and a third sub power line (PWLs3g) connected to the second sub power line (PWLs2g) through a first contact hole (H1g). The third electrode layer (CEL3) may include the first sub power line (PWLs1g). The additional electrode layer (ACEL) may include the second sub power line (PWLs2g). The fourth electrode layer (CEL4) may include the third sub power line (PWLs3g).

The first sub power line (PWLs1g) and the second sub power line (PWLs2g) may be connected to each other through a contact hole or an etched portion, to have the same potential. According to some embodiments, the first sub power line (PWLs1g) and the second sub power line (PWLs2g) are not directly connected to each other, but may be capacitively coupled.

The first contact hole (H1g) may be spaced apart in the second direction (DR2) from an overlapping area of the first sub signal line (SGLs1g) and the second sub signal line (SGLs2g). Referring to FIG. 25, the first sub signal line (SGLs1g) and the second sub signal line (SGLs2g) form a slope at a boundary of the overlapping area. According to some embodiments of the present disclosure, the first contact hole (H1g) may be formed by spacing away from the slope by a specific distance (DIST) or more. For example, the specific distance (DIST) may be 2 micrometers. According to experimental results, the burnt defect rate measured at the specific distance (DIST) of 1.5 micrometers was 2.13%, and the burnt defect rate measured at the specific distance (DIST) of 2 micrometers was 1.07%. In other words, according to some embodiments, the burnt defect rate may be reduced by 2 times (or about 2 times). According to some embodiments, even if the signal line (SGLg) and the power line (PWLg) are positioned to overlap each other, a contact failure or a burnt defect may be prevented or reduced.

According to some embodiments, the first sub signal line (SGLs1g) may include an extension (Exts1g) extending in the second direction (DR2). At this time, the first contact hole (H1g) may be positioned on the extension (Exts1g). According to some embodiments, the gradient of the slope may be relatively reduced. Thus, the contact failure rate or the burnt defect rate may be more reduced.

According to some embodiments, each of the first sub power line (PWLs1g), the second sub power line (PWLs2g), and the third sub power line (PWLs3g) may extend in the second direction (DR2). At this time, the second sub power line (PWLs2g) and the third sub power line (PWLs3g) may be further connected through a second contact hole (H2g) positioned in the second direction (DR2) from the first contact hole (H1g). According to some embodiments, even if a contact failure or a burnt defect occurs in the first contact hole (H1g), the second sub power line (PWLs2g) and the third sub power line (PWLs3g) may be connected to each other by maintaining contact in the second contact hole (H2g) which is more stable. In addition, if there is no defect in both the first contact hole (H1g) and the second contact hole (H2g), the voltage drop of the power line (PWLg) may be reduced more effectively.

Referring to FIG. 25 and FIG. 26, the power line (PWLg) may further include a fourth sub power line (PWLs4g). The fifth electrode layer (CEL5) may include the fourth sub power line (PWLs4g). By removing an insulation layer between the third sub power line (PWLs3g) and the fourth sub power line (PWLs4g), the voltage drop of the power line (PWLg) may be reduced more effectively.

The second sub power line (PWLs2g) and the third sub power line (PWLs3g) may be further connected through a third contact hole (H3g) positioned in the opposite direction of the first direction (DR1) from the first contact hole (H1g). For example, the third contact hole (H3g) may not overlap with the first sub power line (PWLs1g). In addition, the second sub power line (PWLs2g) and the third sub power line (PWLs3g) may be further connected through a fourth contact hole (H4g) positioned in the second direction (DR2) from the third contact hole (H3g). For example, the fourth contact hole (H4g) may not overlap with the first sub power line (PWLs1g). According to some embodiments, the voltage drop of the power line (PWLg) may be reduced more effectively.

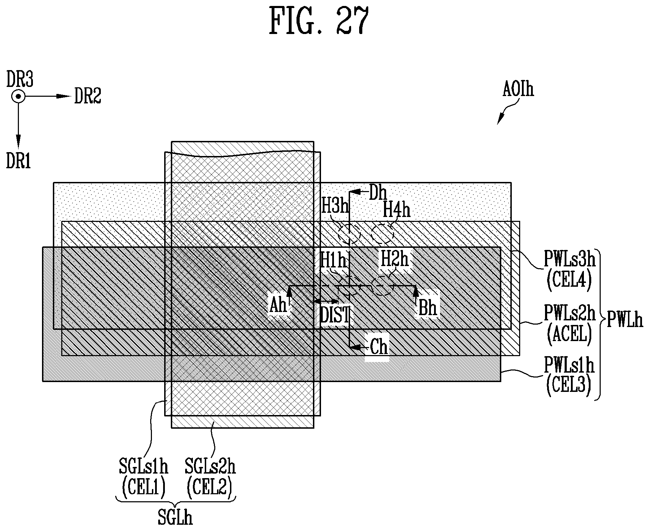

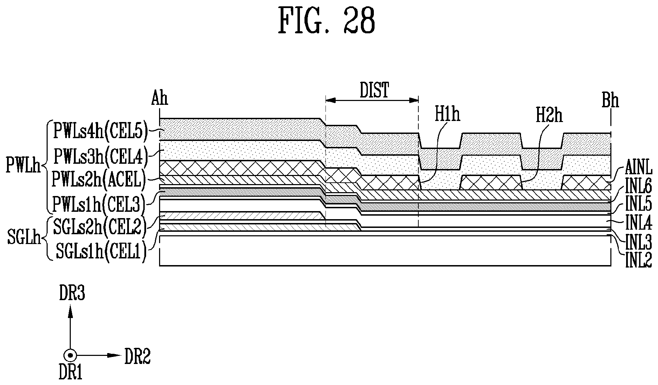

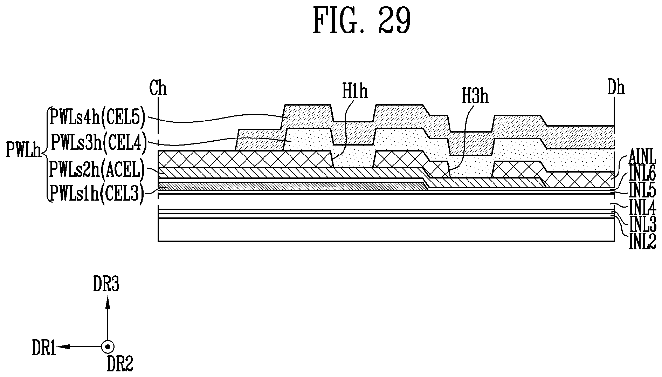

FIG. 27 is a plan view of an area of interest according to some embodiments of the present disclosure. FIG. 28 is a cross-sectional diagram along a line Ah-Bh of the area of interest of FIG. 27. FIG. 29 is a cross-sectional diagram along a line Ch-Dh of the area of interest of FIG. 28.

Referring to FIG. 27, a signal line (SGLh) and a power line (PWLh) may be positioned in an area of interest (AOIh).

The signal line (SGLh) may include a first sub signal line (SGLs1h) and a second sub signal line (SGLs2h). The first electrode layer (CEL1) may include the first sub signal line (SGLs1h). The second electrode layer (CEL2) may include the second sub signal line (SGLs2h).

The first sub signal line (SGLs1h) and the second sub signal line (SGLs2h) may be connected to each other through a contact hole or an etched portion, to have the same potential. According to some embodiments, the first sub signal line (SGLs1h) and the second sub signal line (SGLs2h) may be separated and used to transmit different signals.

The power line (PWLh) may include a first sub power line (PWLs1h), a second sub power line (PWLs2h), and a third sub power line (PWLs3h) connected with the second sub power line (PWLs2h) through a first contact hole (H1h). The third electrode layer (CEL3) may include the first sub power line (PWLs1h). The additional electrode layer (ACEL) may include the second sub power line (PWLs2h). The fourth electrode layer (CEL4) may include the third sub power line (PWLs3h).

The first sub power line (PWLs1h) and the second sub power line (PWLs2h) may be connected to each other through a contact hole or an etched portion, to have the same potential. According to some embodiments, the first sub power line (PWLs1h) and the second sub power line (PWLs2h) are not directly connected to each other, but may be capacitively coupled.

The first contact hole (H1h) may be spaced apart in the second direction (DR2) from an overlapping area of the first sub signal line (SGLs1h) and the second sub signal line (SGLs2h). Referring to FIG. 28, the first sub signal line (SGLs1h) and the second sub signal line (SGLs2h) form a slope at a boundary of the overlapping area. According to some embodiments of the present disclosure, the first contact hole (H1h) may be formed by spacing away from the slope by a specific distance (DIST) or more. For example, the specific distance (DIST) may be 2 micrometers. According to experimental results, the burnt defect rate measured at the specific distance (DIST) of 1.5 micrometers was 2.13%, and the burnt defect rate measured at the specific distance (DIST) of 2 micrometers was 1.07%. In other words, according to some embodiments, the burnt defect rate may be reduced by 2 times (or about 2 times). According to some embodiments, even if the signal line (SGLh) and the power line (PWLh) are positioned to overlap each other, a contact failure or a burnt defect may be prevented or reduced.

Unlike the first sub signal line (SGLs1g) of FIG. 24 through FIG. 26, the first sub signal line (SGLs1h) may not include an extension according to some embodiments. In other words, the first contact hole (H1h) may overlap with neither the first sub signal line (SGLs1h) nor the second sub signal line (SGLs2h).

According to some embodiments, each of the first sub power line (PWLs1h), the second sub power line (PWLs2h), and the third sub power line (PWLs3h) may extend in the second direction (DR2). At this time, the second sub power line (PWLs2h) and the third sub power line (PWLs3h) may be further connected through a second contact hole (H2h) positioned in the second direction (DR2) from the first contact hole (H1h). According to some embodiments, even if a contact failure or a burnt defect occurs in the first contact hole (H1h), the second sub power line (PWLs2h) and the third sub power line (PWLs3h) may be connected to each other by maintaining contact in the second contact hole (H2h) which is more stable. In addition, if there is no failure in both the first contact hole (H1h) and the second contact hole (H2h), the voltage drop of the power line (PWLh) may be reduced more effectively.

Referring to FIG. 28 and FIG. 29, the power line (PWLh) may further include a fourth sub power line (PWLs4h). The fifth electrode layer (CEL5) may include the fourth sub power line (PWLs4h). By removing an insulation layer between the third sub power line (PWLs3h) and the fourth sub power line (PWLs4h), the voltage drop of the power line (PWLh) may be reduced more effectively.

The second sub power line (PWLs2h) and the third sub power line (PWLs3h) may be further connected through a third contact hole (H3h) positioned in the opposite direction of the first direction (DR1) from the first contact hole (H1h). For example, the third contact hole (H3h) may not overlap with the first sub power line (PWLs1h). In addition, the second sub power line (PWLs2h) and the third sub power line (PWLs3h) may be further connected through a fourth contact hole (H4h) positioned in the second direction (DR2) from the third contact hole (H3h). For example, the fourth contact hole (H4h) may not overlap with the first sub power line (PWLs1h). According to some embodiments, the voltage drop of the power line (PWLh) may be reduced more effectively.

As discussed, embodiments can provide a display device comprising: a substrate comprising a display area and a non-display area; a signal line extending in a first direction across the display area and the non-display area; and a power line overlapping with the signal line in the non-display area, and extending in a second direction different from the first direction, wherein the signal line comprises a first sub signal line and a second sub signal line, the power line comprises a first sub power line and a second sub power line connected through a first contact hole, and the first contact hole is spaced apart in the second direction from an overlapping area of the first sub signal line and the second sub signal line.

In some embodiments, there is an insulating layer between the first sub power line and the second sub power line, with the first contact hole being formed in this insulating layer. The second sub power line may be over the first sub power line.

In some embodiments, there is an insulating layer between the first sub signal line and a second sub signal line. The second sub signal line may be over the first sub signal line.

The first sub signal line and the second sub signal line may be connected to each other through a contact hole or an etched portion, to have the same potential. According to some embodiments, the first sub signal line and the second sub signal line may be separated and used to transmit different signals.

In some embodiments, there is an insulating layer between the second sub signal line and the first sub power line. The first sub power line may be over the second sub signal line.

In some embodiments, the display device comprises a first electrode layer that comprises the first sub signal line, a second electrode layer over the first electrode layer, which comprises the second sub signal line, a third electrode layer over the second electrode layer, which comprises the first sub power line, and a fourth electrode layer over the third electrode layer, which comprises the second sub power line. One or more insulating layers may be respectively provided between the electrode layers.

As mentioned above, the first contact hole is spaced apart in the second direction from an overlapping area of the first sub signal line and the second sub signal line. In some embodiments, the first sub signal line and the second sub signal line form a slope at a boundary of the overlapping area. According to some embodiments, the first contact hole may be formed by spacing over a specific distance from such a slope.

The first sub power line and the second sub power line may be further connected through a second contact hole positioned in the second direction from the first contact hole.

Embodiments can provide a display device comprising: a substrate comprising a display area and a non-display area; a signal line extending in a first direction across the display area and the non-display area; and a power line overlapping with the signal line in the non-display area, and extending in a second direction different from the first direction, wherein the signal line comprises a first sub signal line and a second sub signal line, the power line comprises a first sub power line, a second sub power line, and a third sub power line connected to the second sub power line through a first contact hole, and the first contact hole is spaced apart in the second direction from an overlapping area of the first sub signal line and the second sub signal line.

In some embodiments, the display device comprises a first electrode layer that comprises the first sub signal line, a second electrode layer over the first electrode layer, and which comprises the second sub signal line, a third electrode layer over the second electrode layer, and which comprises the first sub power line, an additional electrode layer over the third electrode layer, which comprises the second sub power line, and a fourth electrode layer over the additional electrode layer, and comprises the third sub power line. One or more insulating layers may be respectively provided between the electrode layers.

Embodiments can provide an electronic device comprising: a processor to provide input image data; and a display device to display an image based on the input image data, wherein the display device is according to any of the above discussed embodiments.

A display device according to an embodiment is applicable to various types of electronic devices. In an embodiment, an electronic device includes the above-described display device and may further include other modules or devices having additional functions in addition to the display device.

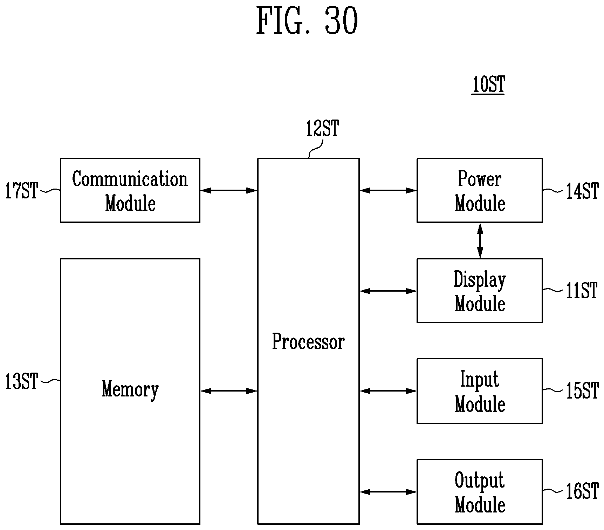

FIG. 30 is a block diagram of an electronic device according to an embodiment. Referring to FIG. 30, the electronic device 10ST may include a display module 11ST, a processor 12ST, a memory 13ST, and a power module 14ST.

The processor 12ST may include at least one of a central processing unit (CPU), an application processor (AP), a graphic processing unit (GPU), a communication processor (CP), an image signal processor (ISP), and a controller. In an embodiment, the processor 12ST may be divided into two or more parts from a functional or structural perspective. For example, the processor 12ST includes a main processor in the form of a first driving chip including a CPU and an auxiliary processor in the form of a second driving chip. The auxiliary processor may include a controller that receives image data signals from the main processor and processes the image data signals to conform to interface specifications of the display module 11ST. The processor 12ST may provide input image data. The display module 11ST may display an image based on the input image data.

The memory 13ST may include at least one of a non-volatile memory and a volatile memory. The memory 13ST may store data and/or information used to operate the processor 12ST or the display module 11ST. When the processor 12ST executes an application stored in the memory 13ST, image data signals and/or input control signals may be transferred to the display module 11ST. The display module 11ST may process the provided signals and output image information on a display screen.

The power module 14ST may include a power supply module, such as a power adapter or a battery device, and a power conversion module. The power conversion module converts power supplied by the power supply module and generates power to operate the electronic device 10ST. Power conversion performed by the power conversion module may include DC-DC conversion, AC-AC conversion, and DC-AC conversion, but embodiments are not limited thereto.

The electronic device 10ST may further include an input module 15ST, a non-image output module 16ST, and/or a communication module 17ST.

The input module 15ST may provide input information to the processor 12ST and/or the display module 11ST. The input module 15ST may include not only a physical button, a keyboard, and a microphone, but also various kinds of sensor modules. Examples of the sensor modules may include a biometric sensor, such as a blood pressure sensor, a blood glucose sensor, an electrocardiogram sensor, and a heart rate sensor, as well as a touch sensor, a pressure sensor, a distance sensor, a position sensor, a digitizer, a motion recognition sensor, a camera sensor (an image sensor), a light receiving sensor, a photoelectric conversion sensor, and a temperature sensor.

The non-image output module 16ST may receive information other than image information from the processor 12ST and provide the information to a user. Examples of the non-image output module 16ST may include an audio module, a haptic module, a light emitting module, and unique functional modules of the electronic device such as a cooling module of a refrigerator.

The communication module 17ST may serve to facilitate information exchange between the electronic device 10ST and an external device, and may include a transmitter and a receiver. The communication module 17ST may include various types of wireless communication modules such as a mobile communication module, a WiFi module, and a Bluetooth module, or various kinds of wired communication modules.

At least one of the above-described components of the electronic device 10ST may be included in the display device according to embodiments as described above. In addition, in terms of functionality, some of the individual modules included in one module may be included in a display device and others may be provided separately from the display device. For example, the display module 11ST is included in the display device, whereas the processor 12ST, the memory 13ST, and the power module 14ST are not included in the display device and are instead provided separately in the electronic device 10ST. In another example, the display device further includes the power module 14ST and the power module 14ST supplies power to the processor 12ST and the memory 13ST that are provided separately from the display device in the electronic device 10ST. However, embodiments are not limited to this example.

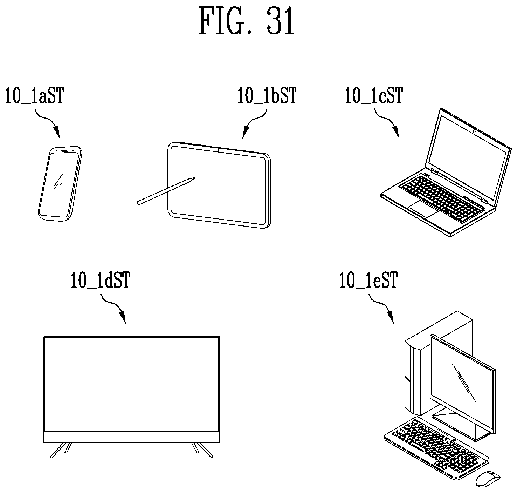

FIGS. 31 to 33 shows schematic views of various embodiments of an electronic device. FIGS. 31 to 33 illustrate examples of various types of electronic devices to which embodiments of a display device are applied.

FIG. 31 shows a smartphone 10_1aST, a tablet PC 10_1bST, a laptop computer 10_1cST, a television (TV) 10_1dST, and a desktop monitor 10_1eST as examples of the electronic device 10ST.

The smartphone 10_1aST may include an input module, such as a touch sensor, and a communication module in addition to the display module 11ST. The smartphone 10_1aST may process information received through the communication module or the input module and display the processed information on the display module of the display device.

Similarly to the smartphone 10_1 aST, the tablet PC 10_1 bST, the laptop computer 10_1cST, the television (TV) 10_1dST, and the desktop monitor 10_1eST may each include a display module and an input module and further include a communication module in some embodiments.

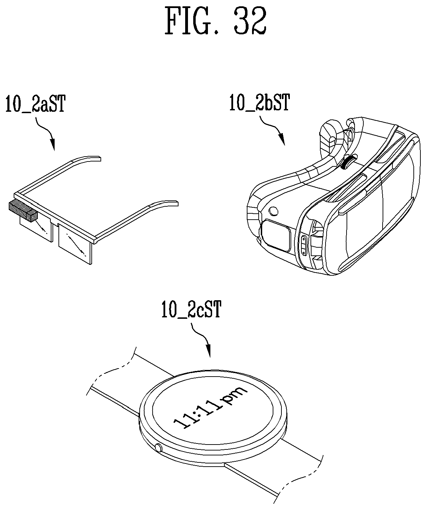

FIG. 32 shows examples in which the electronic device 10ST including the display module 11ST is applied to a wearable electronic device. The examples of the wearable electronic device may include smart glasses 10_2aST, a head-mounted display (HMD) 10_2bST, and a smart watch 10_2cST.

The smart glasses 10_2aST and the head-mounted display 10_2bST may each include a display module that projects a display image and a reflector that reflects the projected display image to direct it to the user's eyes, thereby providing the user with a virtual reality or augmented reality screen.

The smart watch 10_2cST may include a biometric sensor as an input device and provide biometric information detected by the biometric sensor to the user through a display module.

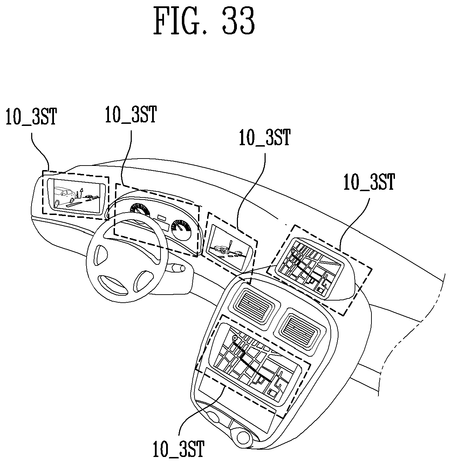

FIG. 33 shows an example in which the electronic device 10ST including the display module 11ST is applied to various kinds of an automotive electronic device 10_3ST. For example, the automotive electronic device 10_3ST is applied to a center information display (CID), which may be employed in the instrument cluster or the center fascia of the vehicle or disposed at the dashboard of the vehicle. The automotive electronic device 10_3ST may also be applied to a room mirror display replacing side mirrors.

Though not shown in FIG. 33, examples of electronic devices to which embodiments of a display device are applied may include various home appliances which display information on display modules, such as refrigerators, washing machines, dryers, air conditioners, and robot vacuum cleaners, as well as devices aimed at displaying screens, such as billboards, electronic display boards, and game consoles. In addition, when a display module has a function of transmitting light, the display module may be applied to an electronic device such as a smart window or a transparent display device which displays a background and a display image together. However, the types of an electronic device according to an embodiment are not limited to the above-described examples, and other various types of electronic devices are applicable.

The drawings referred to so far and the detailed description of embodiments according to the present are merely examples, which are only used for the purpose of explaining aspects of some embodiments according to the present disclosure, and are not used to limit the meaning or the scope of embodiments according to the present disclosure as defined in the claims, in their equivalents. Hence, those skilled in the art will understand that various modifications and other equivalent embodiments are possible therefrom. Accordingly, the scope of embodiments according to the present disclosure should be defined by the appended claims, and their equivalents.

## Claims

1. A display device comprising:
a substrate comprising a display area and a non-display area;
a signal line extending in a first direction across the display area and the non-display area; and
a power line overlapping with the signal line in the non-display area, and extending in a second direction different from the first direction,
wherein the signal line comprises a first sub signal line and a second sub signal line,
wherein the power line comprises a first sub power line and a second sub power line connected through a first contact hole, and
wherein the first contact hole is spaced apart in the second direction from an overlapping area of the first sub signal line and the second sub signal line.

2. The display device according to claim 1, wherein the first contact hole is spaced apart from the overlapping area by 2 micrometers or more.

3. The display device according to claim 1 or 2, comprising:
a first electrode layer that comprises the first sub signal line,
a second electrode layer over the first electrode layer, and which comprises the second sub signal line,
a third electrode layer over the second electrode layer, and which comprises the first sub power line, and
a fourth electrode layer over the third electrode layer, and which comprises the second sub power line.

4. The display device according to claim 3, wherein the first electrode layer comprises a gate electrode of a first transistor, and
wherein the third electrode layer comprises a gate electrode of a second transistor;
optionally wherein a channel of the first transistor and a channel of the second transistor comprise different semiconductor materials.

5. The display device according to claim 3 or 4, wherein the second sub signal line comprises an extension extending in the second direction, and
wherein the first contact hole is positioned on the extension.

6. The display device according to claim 3 or 4, wherein the first sub signal line comprises an extension extending in the second direction, and
wherein the first contact hole is on the extension.

7. The display device according to claim 3 or 4, wherein the first contact hole overlaps with neither the first sub signal line nor the second sub signal line.

8. The display device according to any one of claims 1 to 7, wherein the first sub power line and the second sub power line each extend in the second direction, and
wherein the first sub power line and the second sub power line are further connected through a second contact hole in the second direction from the first contact hole.

9. A display device comprising:
a substrate comprising a display area and a non-display area;
a signal line extending in a first direction across the display area and the non-display area; and
a power line overlapping with the signal line in the non-display area, and extending in a second direction different from the first direction,
wherein the signal line comprises a first sub signal line and a second sub signal line,
wherein the power line comprises a first sub power line, a second sub power line, and a third sub power line connected to the second sub power line through a first contact hole, and
wherein the first contact hole is spaced apart in the second direction from an overlapping area of the first sub signal line and the second sub signal line.

10. The display device according to claim 9, wherein the first contact hole is spaced apart from the overlapping area by 2 micrometers or more.

11. The display device according to claim 9 or 10, comprising:
a first electrode layer that comprises the first sub signal line,
a second electrode layer over the first electrode layer, and which comprises the second sub signal line,
a third electrode layer over the second electrode layer, and which comprises the first sub power line,
an additional electrode layer over the third electrode layer, which comprises the second sub power line, and
a fourth electrode layer over the additional electrode layer, and comprises the third sub power line.

12. The display device according to claim 11, wherein the first electrode layer comprises a gate electrode of a first transistor, and
wherein the third electrode layer comprises a gate electrode of a second transistor;
optionally wherein a channel of the first transistor and a channel of the second transistor comprise different semiconductor materials.

13. The display device according to claim 11 or 12, wherein the second sub signal line comprises an extension extending in the second direction, and wherein the first contact hole is on the extension; or
wherein the first sub signal line comprises an extension extending in the second direction, and wherein the first contact hole is on the extension; or
wherein the first contact hole overlaps with neither the first sub signal line nor the second sub signal line.

14. The display device according to any one of claims 9 to 13, wherein the first sub power line, the second sub power line, and the third sub power line each extend in the second direction, and
wherein the second sub power line and the third sub power line are further connected through a second contact hole arranged in the second direction from the first contact hole;
optionally wherein the second sub power line and the third sub power line are further connected through a third contact hole arranged in a direction opposite to the first direction from the first contact hole, wherein the third contact hole does not overlap with the first sub power line, wherein the second sub power line and the third sub power line are further connected through a fourth contact hole positioned in the second direction from the third contact hole, and wherein the fourth contact hole does not overlap with the first sub power line.

15. An electronic device comprising:
a processor to provide input image data; and
a display device to display an image based on the input image data, wherein the display device is according to any one of claims 1 to 14.
